# EUROPEAN PATENT APPLICATION

(11) **EP 2 799 996 A1**
(43) Date of publication of application: **05.11.2014**
(21) Application number: 14162321.5
(22) Date of filing: 28.03.2014
(51) Int. Cl.: G06F 12/02, G06F 11/00, G11C 16/00

(54) **Information processing apparatus, control circuit, control program, and control method**

(30) Priority: 30.04.2013 JP 2013096046
(71) Applicant: FUJITSU LIMITED, Kawasaki-shi, Kanagawa 211-8588 (JP)
(72) Inventor: Higeta, Masanori, Kanagawa, 211-8588 (JP); Hayasaka, Kazumi, Kanagawa, 211-8588 (JP)
(74) Representative: Hoffmann Eitle

(57) **Abstract**

An information processing apparatus (1) includes a cyclic frequency counter (16) that updates a count value when a process that determines whether data stored in each of multiple storage areas included in NAND devices (7a to 10a) is targeted for a move has been executed on all pieces of data stored in the NAND devices. Furthermore, the information processing apparatus includes a table storing unit (11) that stores therein, when data is stored in one of the NAND devices, the count value of the cyclic frequency counter associated with the data. Furthermore, the information processing apparatus includes a cyclic reference control unit (17) that compares, for each data stored in the NAND devices, a value stored in the table storing unit with the count value of the cyclic frequency counter and then determines whether each piece of data is targeted for a move.

## Description

### FIELD

The embodiments discussed herein are related to an information processing apparatus, a control circuit, a control program, and a control method.

### BACKGROUND

There is a known conventional information processing apparatus that uses nonvolatile memories that operate faster than magnetic disks. A known example of such an information processing system is an information processing apparatus that uses NAND flash memory devices as storage devices. In a description below, the NAND flash memory devices are referred to as NAND devices.

Storage areas in each of the NAND devices are degraded when information is deleted. Consequently, the speed of degradation varies between a storage area, in which frequently updated information is written, and a storage area, in which less frequently updated information is written. Furthermore, if information is written in a NAND device is not updated for a long time, a portion of an element in a storage area in which data is written may sometimes be discharged, and thus bits may also be garbled.

In order to perform leveling the degradation of storage areas or in order to prevent bits from being garbled due to discharge of a portion of an element in a storage area, there is a known technology that includes storing the time at which information is written and the information is rewritten in accordance with the result of the comparison between the stored time and the current time. For example, the information processing apparatus stores therein, for each storage area, the time at which information is written. Then, the information processing apparatus compares the stored time with the current time and then calculates the elapsed time since the information is written. Then, the information processing apparatus determines, in accordance with the result of the comparison between the elapsed time and a predetermined threshold, whether the information is to be rewritten.

As for examples of the conventional technologies, see Japanese Laid-open Patent Publication No. 08-147988, Japanese Laid-open Patent Publication No. 05-198198, and Japanese Laid-open Patent Publication No. 2006-252695.

However, with the technology that includes rewriting information as described above, because the time at which the information is written is stored for each storage area without processing anything, there is a problem in that the total amount of information on the time that is stored in order to calculate the elapsed time increases.

For example, if the total amount of information on the time increases, the size of a storage device that stores therein the time also becomes large; therefore, the size of a circuit for an information processing apparatus becomes large. Furthermore, if the total amount of the information on the time increases, the time period taken to search for the time at which data is written in a storage area targeted for determination becomes long; therefore, the performance of accessing a NAND device drops.

Accordingly, it is an object in one aspect of an embodiment of the present invention to provide an information processing apparatus, a control circuit, a control program, and a control method that reduces the amount of information that indicates the time at which data is written.

### SUMMARY

According to an aspect of an embodiment, an information processing apparatus comprises, a storage device; a counting unit that updates a count value when a process that determines whether data stored in each of multiple storage areas included in the storage device is targeted for a move has been executed on all pieces of the data stored in the storage device; a count value storing unit that stores therein, when the data is written in the storage device, the count value of the counting unit associated with the data; and a determining unit that compares, for each data stored in the storage device, a value stored in the count value storing unit with the count value of the counting unit and that determines whether each piece of the data is targeted for a move.

### BRIEF DESCRIPTION OF DRAWINGS

FIG. 1 is a schematic diagram illustrating an information processing apparatus according to a first embodiment;
FIG. 2 is a schematic diagram illustrating an example of a memory access;
FIG. 3 is a schematic diagram illustrating an example of a process executed by a conventional NAND controller;
FIG. 4 is a schematic diagram illustrating a process executed by using a conventional time stamp;
FIG. 5 is a schematic diagram illustrating a problem of a process executed by using a conventional time stamp;
FIG. 6 is a schematic diagram illustrating the functional configuration of a NAND controller according to the first embodiment;
FIG. 7 is a schematic diagram illustrating an example of information stored in an address conversion table according to the first embodiment;
FIG. 8 is a schematic diagram illustrating an example of information stored in a management information table according to the first embodiment;
FIG. 9 is a schematic diagram illustrating a process executed by the NAND controller;
FIG. 10 is a schematic diagram illustrating data move control;
FIG. 11 is a flowchart illustrating the flow of a process executed by the NAND controller according to the first embodiment;
FIG. 12 is a schematic diagram illustrating the functional configuration of a NAND controller according to a second embodiment;
FIG. 13 is a flowchart (No. 1) illustrating the flow of a process executed by the NAND controller according to the second embodiment;
FIG. 14 is a flowchart (No. 2) illustrating the flow of a process executed by the NAND controller according to the second embodiment;
FIG. 15 is a schematic diagram illustrating the functional configuration of a NAND controller according to a third embodiment;
FIG. 16 is a schematic diagram illustrating an example of thresholds according to an average request issue count;
FIG. 17 is a flowchart illustrating the flow of a process executed by the NAND controller according to the third embodiment;
FIG. 18 is a schematic diagram illustrating an example of a process executed by using a write bit; and
FIG. 19 is a schematic diagram illustrating an example of a NAND controller that executes a control program.

### DESCRIPTION OF EMBODIMENTS

Preferred embodiments of the present invention will be explained with reference to accompanying drawings. The present invention is not limited to the embodiments described below. Furthermore, the embodiments may be appropriately used in combination as long as they do not conflict with each other.

### [a] First Embodiment

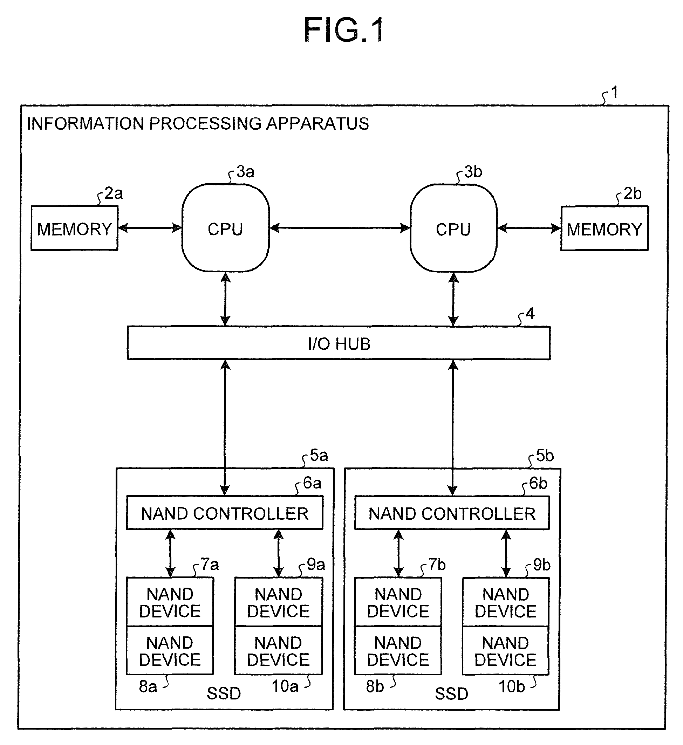

In a first embodiment, an example of an information processing apparatus will be described with reference to FIG. 1. FIG. 1 is a schematic diagram illustrating an information processing apparatus according to a first embodiment. In the example illustrated in FIG. 1, an information processing apparatus 1 includes memories 2a and 2b, central processing units (CPUs) 3a and 3b, an input/output (I/O) hub 4, and multiple solid state drive (SSD) 5a and 5b. The SSD 5a includes a NAND controller 6a and multiple NAND devices 7a to 10a.

The SSD 5b includes a NAND controller 6b and multiple NAND devices 7b to 10b. In the following, a description will be given with the assumption that the NAND controller 6b and the multiple NAND devices 7b to 10b have the same functions as those performed by the NAND controller 6a and the multiple NAND devices 7a to 10a, respectively; therefore, descriptions thereof will be omitted.

The memories 2a and 2b are storage devices that store data that is used for arithmetic processing by the CPUs 3a and 3b, respectively. Furthermore, the CPUs 3a and 3b are arithmetic processing units that perform various kinds of arithmetic processing by using data stored in the memories 2a and 2b, respectively. For example, by using the nonuniform memory access (NUMA) technology, the CPUs 3a and 3b acquire data stored in the memories 2a and 2b, respectively, and execute the arithmetic processing by using the acquired data.

Furthermore, the CPUs 3a and 3b acquire data stored in the SSDs 5a and 5b, respectively, via the I/O hub 4 and execute the arithmetic processing by using the acquired data. Specifically, the CPU 3a issues a read request or a write request for data to the SSD 5a and reads data from or writes data to the NAND devices 7a to 10a. For example, the CPU 3a issues, to the SSD 5a, a read request in which a logical address that specifies data to be read is stored. Furthermore, the CPU 3a issues a write request in which a logical address that specifies the writing destination of the data and data to be written are stored.

The NAND device 7a is a nonvolatile memory that stores therein various kinds of data. Specifically, the NAND device 7a includes multiple pages that correspond to storage areas for data and writes the data in units of a page. Furthermore, the NAND device 7a includes multiple blocks that includes multiple pages and deletes data in units of a block.

The NAND controller 6a accesses each of the NAND devices 7a to 10a and reads and writes data. For example, the NAND controller 6a includes an address conversion table that stores therein, in an associated manner, a logical address, which is used when each of the CPUs 3a and 3b specifies a storage area that stores therein data, and a physical address, which indicates a storage area of each of the NAND devices 7a to 10a in which data is stored.

Then, when the NAND controller 6a receives a logical address together with a read request, the NAND controller 6a identifies, by using the address conversion table, a physical address that is associated with the logical address and then reads data from a storage area that is indicated by the identified physical address. Then, the NAND controller 6a sends the read data to the CPU 3a via the I/O hub 4.

In a description below, for ease of understanding, a logical address that corresponds to the top address in each page is simply referred to as a logical address. Furthermore, a physical address that corresponds to the top address in each page is simply referred to as a physical address. Furthermore, it is assumed that the system executed by the information processing apparatus 1 issues a read request or a write request for a logical address that corresponds to the top address in each page.

For example, if each of the NAND devices 7a to 10a includes multiple blocks and 2^{q} pages are included in each block, the NAND controller 6a executes the following process. Firstly, the NAND controller 6a uses lower q bits in logical addresses as a logical page number that is used to identify a page in a single logical block. Then, the NAND controller 6a uses upper p bits in the remaining logical addresses as logical block addresses that indicate a single logical block.

Furthermore, the NAND controller 6a uses upper p bits in physical addresses as physical block addresses that indicate a single physical block and uses lower q bits in physical addresses as physical page number that is used to identify each page in a single physical block. Namely, the NAND controller 6a divides a logical address into logical block addresses each of which indicates a logical block and logical page numbers each of which indicates a logical page for each logical block. Furthermore, the NAND controller 6a divides a physical address into physical block addresses each of which indicates a physical block and physical page numbers each of which indicates a physical page for each physical block.

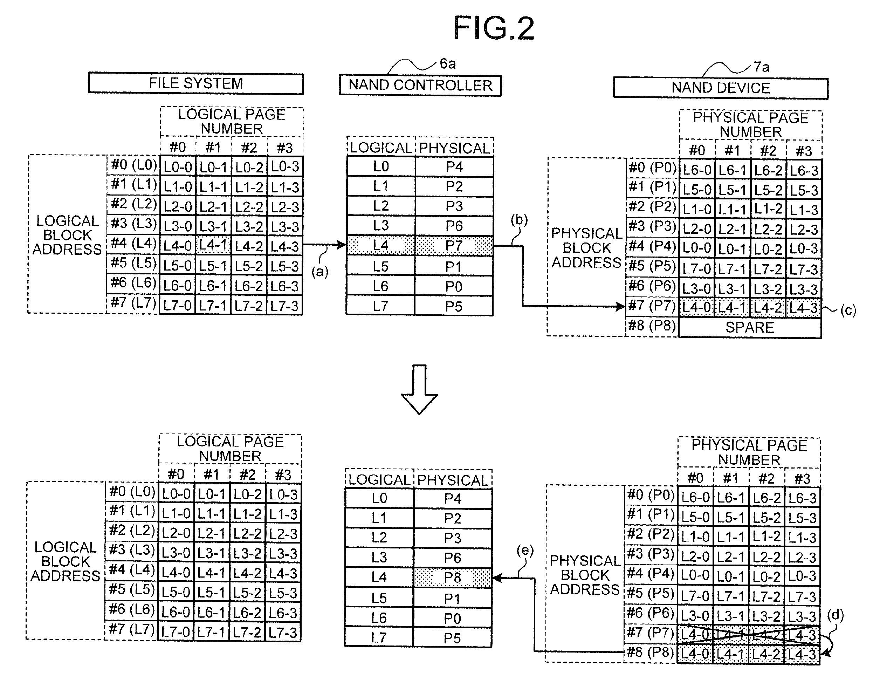

For example, FIG. 2 is a schematic diagram illustrating an example of a memory access. For ease of understanding, FIG. 2 illustrates an example of the NAND device 7a in which the number of blocks is "8" and the number of pages in each block is "4". Furthermore, FIG. 2 illustrates an example of a process performed by the NAND controller 6a that includes the address conversion table in which the logical block addresses and the physical block addresses are stored in an associated manner.

For example, as illustrated by (a) in FIG. 2, the file system executed by the CPU 3a issues a write request for a logical page with the logical page number "1" from among the logical pages in the logical block address "L4". That is, the file system issues a write request for the logical address "L4-1". Then, as illustrated by (b) in FIG. 2, the NAND controller 6a acquires the physical block address "P7" that is associated with the logical block address "L4" and then, as illustrated by (c) in FIG. 2, the NAND controller 6a identifies a block that includes a page to be written.

Subsequently, as illustrated by (d) in FIG. 2, the NAND controller 6a copies all the pieces of data in the physical block indicated by the physical block address "P7" to a spare block. At this point, the NAND controller 6a updates data with the physical page number "1", which is the same page number with the logical page number "1" as that targeted for the write request, to the data targeted for the writing. Then, as illustrated by (e) in FIG. 2, the NAND controller 6a updates the physical block address "P7", which was associated with the logical block address "L4", to the physical block address "P8" for the spare block. Then, the NAND controller 6a deletes the data in the block indicated by the physical block address "P7".

At this point, in order to perform the leveling of the speed of degradation or in order to prevent bits from being garbled due to discharge of a portion of an element, a conventional NAND controller stores therein, as a time stamp, the time at which data is written in each of the blocks in the NAND device. Then, for each block, if a difference between the stored time stamp and the current time is greater than a predetermined threshold, the conventional NAND controller rewrites the data by moving the data stored in the blocks to another blocks.

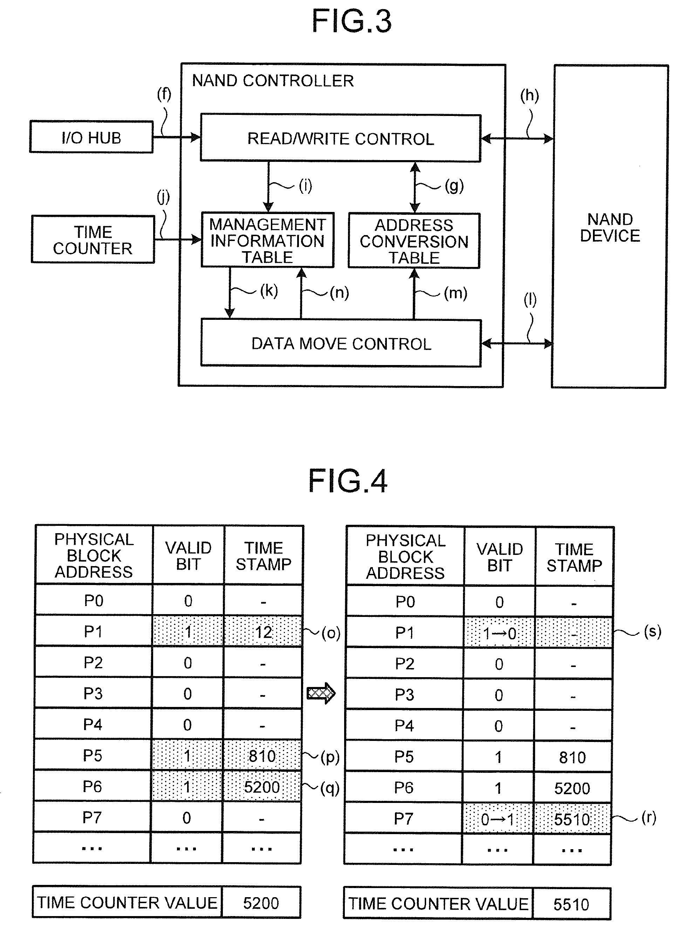

In the following, an example of a process executed by a conventional NAND controller will be described with reference to FIG. 3. FIG. 3 is a schematic diagram illustrating an example of a process executed by a conventional NAND controller. For example, as illustrated by (f) in FIG. 3, the NAND controller receives a read request or a write request from an I/O hub. Then, the NAND controller executes read/write control. For example, as illustrated by (g) in FIG. 3, the NAND controller converts a logical address to a physical address by using the address conversion table. Then, as illustrated by (h) in FIG. 3, the NAND controller executes a reading process or a writing process on a NAND device by using the converted logical address.

The NAND controller includes a management information table that stores therein, in an associated manner, a physical address that indicates each block included in a NAND device, a valid bit that indicates whether data has been written, and a time stamp that indicates the time at which the data is written. When a writing process has been executed on the NAND device, as illustrated by (i) in FIG. 3, the NAND controller stores, in an associated manner in the management information table, the time at which the data has been written, the block in which the data has been written, and the valid bit. For example, as illustrated by

(j) in FIG. 3, the NAND controller stores, in an associated manner in the management information table, the time at which a time counter counted at the time of the writing of the data, the physical block address that indicates the block in which the data has been written, and the valid bit "1".

Furthermore, the NAND controller executes data move control. For example, as illustrated by (k) in FIG. 3, the NAND controller compares the time stored in the management information table with the current time counted by the time counter and then identifies data that has been stored for a predetermined time period after the data was written. Then, as illustrated by (l) in FIG. 3, the NAND controller moves the identified data to another block. Thereafter, as illustrated by (m) in FIG. 3, the NAND controller updates the address conversion table in accordance with the moving of data, and updates the management information table as illustrated by (n) in FIG. 3.

In the following, a process in which a conventional NAND controller identifies, by using a time stamp, data to be moved will be described with reference to FIG. 4. FIG. 4 is a schematic diagram illustrating a process executed by using a conventional time stamp. FIG. 4 illustrates data stored in the management information table in the conventional NAND controller and values counted by the time counter.

For example, when the time counter value counted by the time counter is "12", if the NAND controller writes data in the block indicated by the physical block address "P1", the NAND controller executes the following process. Namely, as illustrated by (o) in FIG. 4, the NAND controller stores, in an associated manner, the physical block address "P1", the valid bit "1", and the time stamp "12".

Furthermore, when the time counter value counted by the time counter is "810", if the NAND controller writes data in the block indicated by the physical block address "P5", the NAND controller executes the following process. Namely, as illustrated by (p) in FIG. 4, the NAND controller stores, in an associated manner in the management information table, the physical block address "P5", the valid bit "1", and the time stamp "810".

Furthermore, when the time counter value counted by the time counter is "5200", if the NAND controller writes data in the block indicated by the physical block address "P6", the NAND controller executes the following process. Namely, as illustrated by (q) in FIG. 4, the NAND controller stores, in an associated manner in the management information table, the physical block address "P6", the valid bit "1", and the time stamp "5200".

Furthermore, the NAND controller refers to a value of each of the time stamps stored in the management information table at predetermined time intervals and then identifies physical blocks that are associated with the time stamp in which the difference between the value of the time stamp and the value currently indicated by the time counter is greater than a predetermined threshold. For example, in the example illustrated in FIG. 4, the NAND controller identifies the physical block address "P1" that is associated with the time stamp "12" in which the difference with the current value "5510" of the time counter is great. Then, the NAND controller moves the data in the block indicated by the physical block address "P1" to the block indicated by, for example, the physical block address "P7".

Thereafter, as illustrated by (r) in FIG. 4, the NAND controller updates the valid bit associated with the physical block address "P7" to "1" and then associates the valid bit with the value "5510" of the current time as the time stamp. Furthermore, as illustrated by (s) in FIG. 4, the NAND controller updates the valid bit associated with the physical block address "P1" to "0" and then deletes the value of the time stamp.

However, because the conventional NAND controller stores a time stamp for each physical block address, the size of data stored in the management information table becomes large. For example, if the size of a single page is 8 kilobytes and 128 pages are included in a single block, the NAND controller stores, in the management information table, a time stamp with multiple digits for each megabyte. Therefore, as the capacity of each of the NAND devices 7a to 10a increases, the size of the management information table becomes large. Consequently, with the conventional NAND controller, the size of a circuit used to store the management information table becomes large or the time period taken to refer to a time stamp increases; therefore, the performance of accessing a NAND device is dropped.

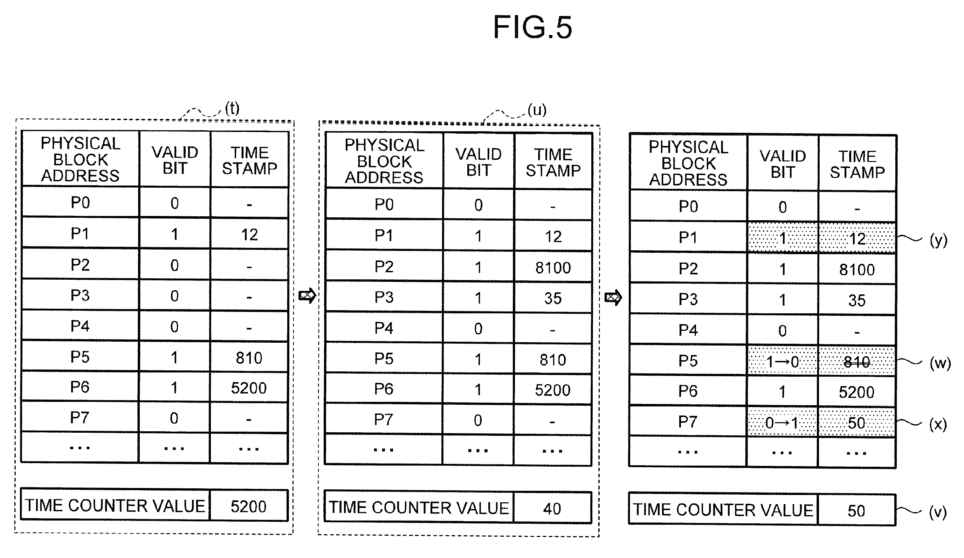

In order to reduce the size of data in the management information table, it is conceivable to use a method that returns the value of the time counter to the initial value with a predetermined number of digits. However, if a value of the time counter is returned to the initial value with a predetermined number of digits, after the values of the time counter has been wrapped around, a malfunction may possibly occur. In the following, an example of a malfunction that occurs after a round of the values of the time counter will be described with reference to FIG. 5.

FIG. 5 is a schematic diagram illustrating a problem of a process executed by using a conventional time stamp. In the example illustrated in FIG. 5, a description will be given in a case in which the value of the time counter overflows at "9999" and returns to the initial value "0". For example, as illustrated by (t) in FIG. 5, when the values of the time counter are "12", "810", and "5200", the NAND controller stores, in the management information table, information indicating that data is written in the blocks indicated by the physical block addresses "P1", "P5", and "P6".

Then, as illustrated by (u) in FIG. 5, when the value of the time counter is "8100", the NAND controller stores, in the management information table, information indicating that data is written in the block indicated by the physical block address "P2". Furthermore, when the value of the time counter is wrapped around and becomes "35", the NAND controller stores, in the management information table, information indicating that data is written in the block indicated by the physical block address "P3".

Then, as illustrated by (v) in FIG. 5, the NAND controller refers to the value of each of the time stamps when the value of the time counter is "50" and searches for, by taking into consideration the value of the time counter is wrapped around, a time stamp with a value that has a great difference with the value "50" of the time counter. The oldest data stored in the NAND devices 7a to 10a is data that is stored in the block indicated by the physical block address "P1" that is associated with the time stamp "12".

However, if a process for moving data is postponed or if the completion of the moving process is delayed due to high priority read requests or write requests being issued in a concentrated manner, there may sometimes be a case in which the value of the time counter exceeds the value of the time stamp. In such a case, the NAND controller is not able to determine whether the value of the time stamp is a value that is within the value of the time counter before it is wrapped around.

Consequently, as illustrated by (w) in FIG. 5, the NAND controller determines that the value "810" of the time stamp associated with the physical block address "P5" is the oldest value of the time stamp. Then, the NAND controller deletes the value "810" of the time stamp that is associated with the physical block address "P5". Furthermore, as illustrated by (x) in FIG. 5, the NAND controller moves the data that is stored in the block indicated by the physical block address "P5" to the block indicated by the physical block address "P7".

As described above, as illustrated by (y) in FIG. 5, even when the data stored in the block indicated by the physical block address "P1" is the oldest data, the conventional NAND controller is not able to detect that the data is the oldest data. Therefore, the NAND controller 6a according to the first embodiment executes the following process.

Namely, the NAND controller 6a includes a cyclic frequency counter that updates a count value when a process that determines whether data stored in the NAND devices 7a to 10a is targeted for a move has been executed on all pieces of data. Furthermore, when the NAND controller 6a writes data in the NAND devices 7a to 10a, the NAND controller 6a stores therein a count value of the cyclic frequency counter. Specifically, the NAND controller 6a stores therein, in an associated manner, the physical block address that indicates the block in which data is written and a count value of the cyclic frequency counter.

Then, the NAND controller 6a compares, for each piece of data, a count value that is stored by being associated with the physical block address in which data is stored with a count value of the cyclic frequency counter and then determines whether data in each block is targeted for a move. Consequently, even if the number of digits of the count value that is counted by the cyclic frequency counter is reduced, the NAND controller 6a can prevent a state in which a count value that is counted by the cyclic frequency counter exceeds the count value that is stored when data is written or is moved.

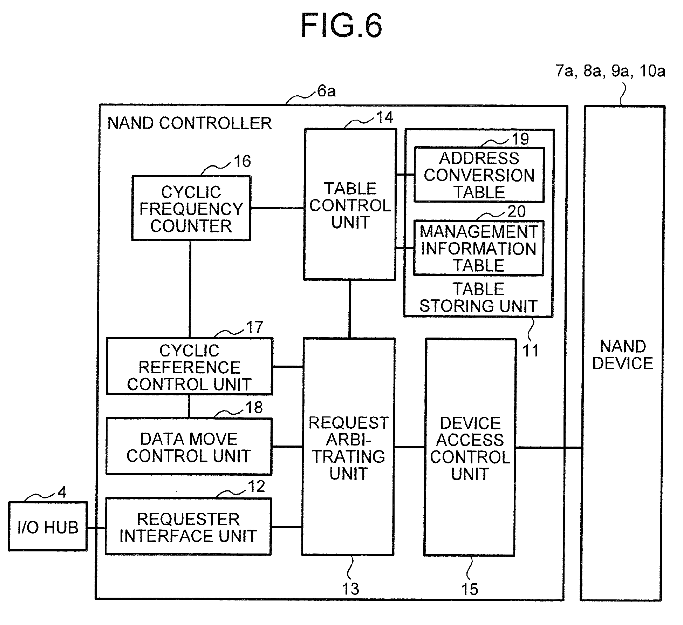

In the following, an example of the functional configuration of the NAND controller 6a will be described with reference to FIG. 6. FIG. 6 is a schematic diagram illustrating the functional configuration of a NAND controller according to the first embodiment. In the example illustrated in FIG. 6, the NAND controller 6a includes a table storing unit 11, a requester interface unit 12, a request arbitrating unit 13, a table control unit 14, and a device access control unit 15. Furthermore, the NAND controller 6a includes a cyclic frequency counter 16, a cyclic reference control unit 17, and a data move control unit 18. The table storing unit 11 stores therein an address conversion table 19 and a management information table 20.

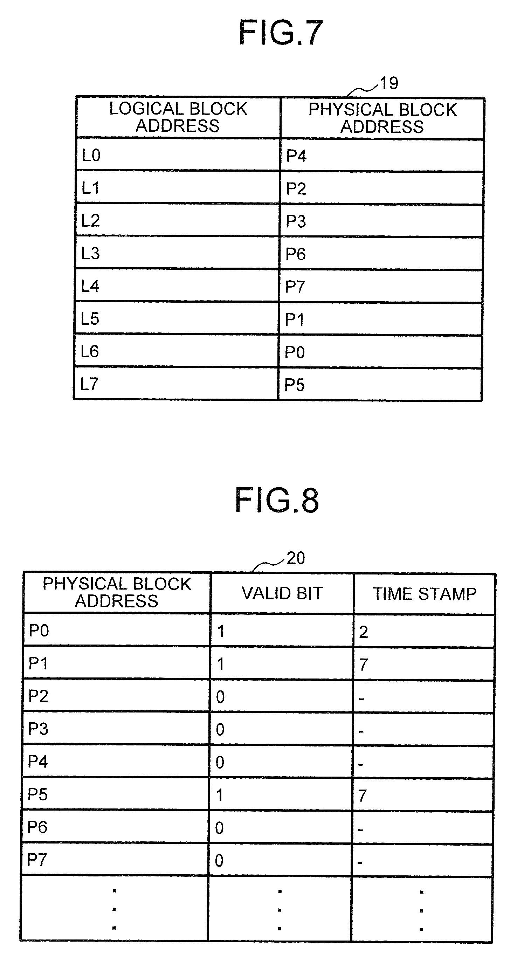

In the following, at first, information that is stored in the address conversion table 19 and the management information table 20 in the table storing unit 11 will be described with reference to FIGS. 7 and 8. FIG. 7 is a schematic diagram illustrating an example of information stored in an address conversion table according to the first embodiment. As illustrated in FIG. 7, the address conversion table 19 stores therein, in an associated manner, the logical block addresses and the physical block addresses.

In the example illustrated in FIG. 7, the address conversion table 19 stores therein, in an associated manner, the logical block address "L0" and the physical block address "P4". That is, the address conversion table 19 indicates that data that is specified by the logical block address "L0" is stored in a block that is indicated by the physical block address "P4".

Similarly, in the example illustrated in FIG. 7, the address conversion table 19 stores therein, in an associated manner, the logical block address "L1" and the physical block address "P2" and stores therein, in an associated manner, the logical block address "L2" and the physical block address "P3". Furthermore, the address conversion table 19 stores therein, in an associated manner, the logical block address "L3" and the physical block address "P6" and stores therein, in an associated manner, the logical block address "L4" and the physical block address "P7".

Furthermore, the address conversion table 19 stores therein, in an associated manner, the logical block address "L5" and the physical block address "P1" and stores therein, in an associated manner, the logical block address "L6" and the physical block address "P0". Furthermore, the address conversion table 19 stores therein, in an associated manner, the logical block address "L7" and the physical block address "P5".

In the following, information stored in the management information table 20 will be described with reference to FIG. 8. FIG. 8 is a schematic diagram illustrating an example of information stored in a management information table according to the first embodiment. As illustrated in FIG. 8, the management information table 20 stores therein, in an associated manner, a physical block address, a valid bit, and a time stamp. The valid bit mentioned here means information that indicates whether data is written in a block that is indicated by an associated physical block address. The time stamp mentioned here means a count value that has been counted by the cyclic frequency counter 16 when data is written in a block indicated by an associated physical block address. Therefore, the NAND controller 6a stores therein, in an associated manner, a count value obtained when data is written and a physical block address.

For example, in the example illustrated in FIG. 8, the management information table 20 stores therein, in an associated manner, the physical block address "P0", the valid bit "1", and the time stamp "2". That is, the management information table 20 indicates that the count value of the cyclic frequency counter 16 is "2" in the storage area indicated by the physical block address "P0".

Similarly, in the example illustrated in FIG. 8, the management information table 20 stores therein, in an associated manner, the physical block address "P1", the valid bit "1", and the time stamp "7". Furthermore, the management information table 20 stores therein, in an associated manner, the physical block address "P5", the valid bit "1", and the time stamp "7". In this way, the management information table 20 stores therein a value of the cyclic frequency counter 16 that is obtained when data is written. The table storing unit 11 that stores therein the management information table 20 is an example of a count value storing unit described in the CLAIMS.

A description will be given here by referring back to FIG. 6. The requester interface unit 12 is an interface for a request sent from the CPU 3a or 3b to one of the NAND devices 7a to 10a. For example, the requester interface unit 12 receives a read request that includes a logical address from one of the CPUs 3a and 3b via the I/O hub 4. In such a case, the requester interface unit 12 outputs a read request to the request arbitrating unit 13. Furthermore, when the requester interface unit 12 receives, from the request arbitrating unit 13, data that is read from one of the NAND devices 7a to 10a, the requester interface unit 12 sends the data to the CPU 3a or 3b that is the requester of the read request.

Furthermore, the requester interface unit 12 receives, from the CPU 3a or 3b, a write request that includes therein data to be written in one of the NAND devices 7a to 10a and the logical address that indicates the data to be written. In such a case, the requester interface unit 12 outputs the received write request to the request arbitrating unit 13. Furthermore, when the requester interface unit 12 receives a response from the request arbitrating unit 13 indicating that the writing of the data has been completed, the requester interface unit 12 sends the received response to the CPU 3a or 3b that is the requester of the write request, as a response.

The request arbitrating unit 13 arbitrates various requests issued by the requester interface unit 12, the data move control unit 18, and the cyclic reference control unit 17. Specifically, the request arbitrating unit 13 receives a read request or a write request from the requester interface unit 12. Furthermore, the request arbitrating unit 13 receives, from the data move control unit 18, a move request for the data stored in one of the NAND devices 7a to 10a to be moved from the currently stored block to another block. Furthermore, the request arbitrating unit 13 receives, from the cyclic reference control unit 17, a table referring request for the management information table 20 to be referred to.

Then, the request arbitrating unit 13 arbitrates a read request, a write request, a move request, and a table referring request that are received from one of the requester interface unit 12, the data move control unit 18, and the cyclic reference control unit 17. For example, the request arbitrating unit 13 executes a read request and a write request issued by the requester interface unit 12 with the highest priority such that the reading or the writing of data with respect to the NAND devices 7a to 10a from the CPU 3a or 3b is not inhibited. Furthermore, for example, the request arbitrating unit 13 executes a move request with priority over a table referring request. The rule for arbitrating each request performed by the request arbitrating unit 13 is not limited to the process described above. An arbitrary rule may also be used.

In the following, an example of a process executed by the request arbitrating unit 13 when the request arbitrating unit 13 receives a read request, a write request, a move request, or a table referring request will be described. For example, when the request arbitrating unit 13 receives a read request, the request arbitrating unit 13 outputs the logical address included in the read request to the table control unit 14. When the request arbitrating unit 13 receives, from the table control unit 14, a physical address to be read, the request arbitrating unit 13 issues, to the device access control unit 15, a read request that stores therein the received physical address. Thereafter, when the request arbitrating unit 13 receives, from the device access control unit 15, data to be read, the request arbitrating unit 13 outputs the received data to the requester interface unit 12.

Furthermore, when the request arbitrating unit 13 receives a write request, the request arbitrating unit 13 outputs the logical address included in the write request to the table control unit 14. Consequently, if data to be written is new data, the request arbitrating unit 13 receives, from the table control unit 14, a physical address for a page, in which data is to be written, in spare blocks in which no data is stored.

Then, the request arbitrating unit 13 issues, to the device access control unit 15, a write request that includes therein the physical address that is received from the table control unit 14 and the data to be written. Furthermore, the request arbitrating unit 13 outputs, to the table control unit 14, a table update request that includes therein the physical address for the page in which the data is to be written and the logical address that is included in the write request.

If the writing of data intends the updating of the data, the request arbitrating unit 13 receives, as an update source physical address from the table control unit 14, a physical address for the page in which update source data is stored. Furthermore, the request arbitrating unit 13 receives, as an update destination physical address from the table control unit 14, the physical address for the page included in spare blocks, i.e., the physical address for a page in which the data is to be written.

When the request arbitrating unit 13 receives the update source physical address and the update destination physical address from the table control unit 14, the request arbitrating unit 13 issues, to the device access control unit 15, an update request for the data to be updated. Specifically, the request arbitrating unit 13 issues, to the device access control unit 15, an update request that includes therein an update source physical address, an update destination physical address, and the data to be written.

Furthermore, the request arbitrating unit 13 outputs, to the table control unit 14, the table update request that includes therein the update source physical address, the update destination physical address, and the logical address that is included in the write request. Thereafter, when the request arbitrating unit 13 receives a response from the device access control unit 15 indicating that the writing of the data has been completed, the request arbitrating unit 13 outputs the received response to the requester interface unit 12.

Furthermore, the request arbitrating unit 13 receives a move request that includes therein a physical block address that indicates the block in which data to be moved is stored. Hereinafter, a physical block address that indicates a block in which data to be moved is stored is referred to as a move source physical block address. Furthermore, the request arbitrating unit 13 refers to the table control unit 14, for example, and acquires, as a move destination physical block address, a physical block address for a spare block, i.e., a physical block address that indicates a block at the move destination of the data.

Then, the request arbitrating unit 13 issues, to the device access control unit 15, a move request that includes therein the move source physical block address and the move destination physical block address. Furthermore, the request arbitrating unit 13 outputs, to the table control unit 14, a table update request that includes therein the move source physical block address and the move destination physical block address. Thereafter, when the request arbitrating unit 13 receives a response from the device access control unit 15 indicating that the moving of the data has been completed, the request arbitrating unit 13 outputs a response to the data move control unit 18 indicating that the moving of the data has been completed.

Furthermore, when the request arbitrating unit 13 receives a table referring request, the request arbitrating unit 13 sends a reference request for the management information table 20 to the table control unit 14. When the request arbitrating unit 13 receives the management information table 20 from the table control unit 14, the request arbitrating unit 13 outputs the received information to the cyclic reference control unit 17.

The table control unit 14 converts a logical address to a physical address. For example, when the table control unit 14 receives, from the request arbitrating unit 13, a logical address stored in the read request, the table control unit 14 extracts a logical block address included in the received logical address. Furthermore, the table control unit 14 refers to the address conversion table 19 and acquires a physical block address that is associated with the extracted logical block address.

Then, the table control unit 14 creates a physical address by combining the logical page number that is included in the received logical address with the acquired physical block address. Specifically, the table control unit 14 converts higher-order bits of the logical address to the physical block address and then combines the physical block address with the lower-order bits of the logical address, whereby the table control unit 14 creates a physical address. Then, the table control unit 14 outputs the created physical address to the request arbitrating unit 13.

Furthermore, when the table control unit 14 receives a logical address stored in a write request from the request arbitrating unit 13, the table control unit 14 searches the address conversion table 19 for a physical block address that is associated with the logical block address. Then, if a physical block address that is associated with the logical block address is not stored in the address conversion table 19, i.e., if data to be written is new data, the table control unit 14 executes the following process.

Firstly, the table control unit 14 refers to the management information table 20 and then identifies a physical block address in which data is not stored, i.e., a physical block address for a spare block. For example, the table control unit 14 refers to the management information table 20, detects a physical block address that is associated with the valid bit "0", and then defines the detected physical block address as the physical block address in the spare block. Then, the table control unit 14 outputs, to the request arbitrating unit 13, a physical address that is obtained by combining the identified physical block address with the logical page number of the received logical address.

In contrast, if a physical block address that is associated with the received logical block address is stored in the address conversion table 19, i.e., if the writing of the data indicates the updating of the data, the table control unit 14 executes the following process. Firstly, the table control unit 14 acquires a physical block address that is associated with the received logical block address and then outputs, as an update source physical address to the request arbitrating unit 13, a physical address that is obtained by combining the acquired physical block address with the logical page number. Furthermore, the table control unit 14 outputs, to the request arbitrating unit 13 as an update destination physical address, a physical address that is obtained by combining the physical block address for a spare block with the logical page number of the received logical address.

Furthermore, when the request arbitrating unit 13 receives a move request, the table control unit 14 receives an inquiry about a physical block address for a spare block from the request arbitrating unit 13. In such a case, the table control unit 14 refers to the management information table 20 and identifies a physical block address that is associated with the valid bit "0". Then, the table control unit 14 outputs the identified physical block address as a move destination physical block address to the request arbitrating unit 13.

Furthermore, in accordance with the writing or moving of data, the table control unit 14 updates the address conversion table 19 and the management information table 20. For example, when the request arbitrating unit 13 writes new data, the table control unit 14 receives a table update request that includes a physical address for a page in which data is to be written and a logical address that is included in the write request.

In such a case, the table control unit 14 extracts a logical block address from the logical address included in the write request and extracts a physical block address from the physical address included in the write request. Then, the table control unit 14 associates the extracted logical block address with the extracted physical block address and then stores the associated addresses in the address conversion table 19.

Furthermore, from among the entries in the management information table 20, the table control unit 14 extracts an entry in which the extracted physical block address is stored and then updates the valid bit that is stored in the extracted entry to "1". Furthermore, the table control unit 14 acquires a value of the cyclic frequency counter 16 and then stores, in the extracted entry, the acquired value as a time stamp.

For example, when the count value of the cyclic frequency counter 16 is "7", the table control unit 14 receives a table update request in which the physical address that includes therein the physical block address "P1" is stored. In this example, the table control unit 14 extracts, from the management information table 20, an entry in which the physical block address "P1" is stored.

Then, the table control unit 14 updates the valid bit in the extracted entry to "1" and then stores the time stamp "7". Consequently, the management information table 20 stores therein, in an associated manner, the physical block address "P1", the valid bit "1", and the time stamp "7".

Furthermore, when the request arbitrating unit 13 updates data, the table control unit 14 receives a table update request that includes therein an update source physical address, an update destination physical address, and a logical address that is included in the write request. In such a case, the table control unit 14 extracts a physical block address included in the update source physical address as an update source physical block address and then extracts a physical block address included in the update destination physical address as an update destination physical block address. Furthermore, the table control unit 14 extracts a logical block address from the logical address that is included in the table update request.

Furthermore, the table control unit 14 extracts an entry that stores therein the logical block address from the address conversion table 19. Then, the table control unit 14 updates the physical block address that is stored in the extracted entry to an update destination physical block address.

Furthermore, the table control unit 14 extracts an entry that stores therein the update source physical block address from the management information table 20, updates the valid bit that is stored in the extracted entry to "0", and then deletes the value of the time stamp. Furthermore, the table control unit 14 extracts an entry that stores therein the update destination physical block address from the management information table 20 and then updates the valid bit that is stored in the extracted entry to "1". Then, the table control unit 14 acquires a value of the cyclic frequency counter 16 and stores, in the extracted entry, the acquired value as the time stamp.

Furthermore, when the request arbitrating unit 13 moves data, the table control unit 14 receives a table update request that includes both a move source physical block address and a move destination physical block address. In such a case, the table control unit 14 extracts an entry that stores therein the move source physical block address from the address conversion table 19. Then, the table control unit 14 updates the move source physical block address that is stored in the extracted entry to a move destination physical block address.

Furthermore, the table control unit 14 extracts, from the management information table 20, an entry that stores therein a move source physical block address, updates the valid bit that is stored in the extracted entry to "0", and then deletes the value of the time stamp. Then, the table control unit 14 extracts an entry that stores therein a move destination physical block address from the management information table 20 and then updates the valid bit that is stored in the extracted entry to "1". Furthermore, the table control unit 14 acquires a value of the cyclic frequency counter 16 and stores, in the extracted entry, the acquired value as the time stamp.

For example, when the count value of the cyclic frequency counter 16 is "7", the table control unit 14 receives a table update request that stores therein the move source physical block address "P0" and the move destination physical block address "P4". In this example, the table control unit 14 extracts an entry that stores therein the physical block address "P0" from the address conversion table 19 and then updates the physical block address "P0" in the extracted entry to the move destination physical block address "P4".

Furthermore, the table control unit 14 extracts an entry that stores therein the move source physical block address "P0" from the management information table 20. Then, the table control unit 14 updates the valid bit "1" in the extracted entry to "0" and then deletes the value of the time stamp. Furthermore, the table control unit 14 extracts an entry that stores therein the move destination physical block address "P4" from the management information table 20 and then updates the valid bit in the extracted entry to "1". Then, the table control unit 14 stores, in the extracted entry, the value "7" of the cyclic frequency counter 16 as the time stamp.

Furthermore, when the table control unit 14 receives a table referring request, the table control unit 14 acquires the management information table 20 from the table storing unit 11. Then, the table control unit 14 outputs the acquired management information table 20 to the request arbitrating unit 13.

The device access control unit 15 accesses the NAND devices 7a to 10a in accordance with various requests from the request arbitrating unit 13. For example, the device access control unit 15 receives a read request that includes therein a physical address from the request arbitrating unit 13. In such a case, the device access control unit 15 reads data stored in a page that is indicated by the physical address stored in the read request from among the pages stored in the NAND devices 7a to 10a. Then, the device access control unit 15 outputs the read data to the request arbitrating unit 13.

Furthermore, for example, the device access control unit 15 receives, from the request arbitrating unit 13, a write request that includes therein a physical address and data to be written. In such a case, the device access control unit 15 stores, in the page indicated by the physical address included in the write request, data that is to be written. Then, the device access control unit 15 outputs a response to the request arbitrating unit 13 indicating that the writing of the data has been completed.

Furthermore, for example, the device access control unit 15 receives, from the request arbitrating unit 13, an update request that includes therein an update source physical address, an update destination physical address, and data to be written. In such a case, the device access control unit 15 reads data in a block that includes the page indicated by the update source physical address. Subsequently, the device access control unit 15 updates the data, out of the read data, stored in the page indicated by the update source physical address to the data that is included in the update request.

Then, the device access control unit 15 stores each piece of data including the updated data in the block that includes the page that is indicated by the update destination physical address. The device access control unit 15 stores the data such that the page number of the page, in which each piece of data at the update source is stored, is the same as the page number of the page, in which each piece of data at the update destination is stored. Then, the device access control unit 15 outputs a response to the request arbitrating unit 13 indicating that the writing of the data has been completed.

Furthermore, the device access control unit 15 receives, from the request arbitrating unit 13, a move request that includes a move source physical block address and a move destination physical block address. In such a case, the device access control unit 15 reads data from the block indicated by the move source physical block address. Then, the device access control unit 15 stores the read data in the block that is indicated by the move destination physical block address. The device access control unit 15 stores data such that the page number of a page, in which each piece of data at the move source is stored, is the same as the page number of a page, in which each piece of data at the move destination is stored. Then, the device access control unit 15 outputs a response to the request arbitrating unit 13 indicating that the moving of the data has been completed.

The cyclic frequency counter 16 counts the number of cyclic reference processes executed by the NAND controller 6a. The cyclic reference process is executed, for all of the blocks in the NAND devices 7a to 10a, to determine whether a predetermined time period has elapsed since data has been written. Namely, the cyclic frequency counter 16 is not a counter that counts, for example, the time at an individual timing but is a counter that updates a count value when the cyclic reference process executed by the NAND controller 6a is ended. Furthermore, the cyclic frequency counter 16 is a counter for a predetermined digit, for example, a single digit, and is a counter in which a count value returns to the initial value "0" when an overflow has occurred. The cyclic frequency counter 16 is an example of a counting unit described in the CLAIMS.

The cyclic reference control unit 17 executes cyclic reference control at a predetermined timing. For example, the cyclic reference control unit 17 executes the cyclic reference control at predetermined time intervals, at the predetermined time, or triggered to execute when an instruction issued by an application program that is executed by the information processing apparatus 1 is received.

In the following, a description will be given of the process of the cyclic reference control executed by the cyclic reference control unit 17. For example, the cyclic reference control unit 17 outputs a reference request for the management information table 20 to the request arbitrating unit 13. Furthermore, the cyclic reference control unit 17 acquires a count value of the cyclic frequency counter 16. Furthermore, when the cyclic reference control unit 17 receives the management information table 20 from the request arbitrating unit 13, the cyclic reference control unit 17 extracts a top entry from the management information table 20 and executes the following determining process.

Firstly, the cyclic reference control unit 17 determines whether the valid bit of the extracted entry is "1". If the valid bit of the extracted entry is not "1", the cyclic reference control unit 17 extracts the subsequent entry from the management information table 20. In contrast, if the valid bit of the extracted entry is "1", the cyclic reference control unit 17 compares the value of the time stamp stored in the extracted entry with the count value of the cyclic frequency counter 16.

Then, the cyclic reference control unit 17 determines, in accordance with the comparison result, whether data is targeted for a move. For example, if the data is not updated in a predetermined time period since the data has been written, the cyclic reference control unit 17 determines that the data is targeted for a move. Thereafter, if the cyclic reference control unit 17 determines that the data is targeted for a move, the cyclic reference control unit 17 outputs the physical block address in the extracted entry to the data move control unit 18. If the cyclic reference control unit 17 receives a response from the data move control unit 18 indicating that the moving of the data has been completed, the cyclic reference control unit 17 extracts the subsequent entry from the management information table 20 and executes a determining process on the extracted entry.

For example, if a value obtained by adding 1 to the value of the cyclic frequency counter 16 matches the value of the time stamp that is stored in the extracted entry, the cyclic reference control unit 17 outputs the physical block address stored in the extracted entry to the data move control unit 18. Namely, if data is not moved or updated until the cyclic frequency counter 16 wraps around since the data has been written in the block indicated by the physical block address that is stored in the extracted entry, the cyclic reference control unit 17 allows the data move control unit 18 to move the data.

Furthermore, if the cyclic reference control unit 17 receives a response from the data move control unit 18 indicating that the moving has been completed for all pieces of the data that are determined to be moved, the cyclic reference control unit 17 increments the value of the cyclic frequency counter 16 by one. Namely, if the determining process is executed on all of the entries in the management information table 20, the cyclic reference control unit 17 increments the value of the cyclic frequency counter 16 by one. Consequently, because the NAND controller 6a reliably moves data to be moved, the count value of the cyclic frequency counter 16 does not exceed the value of the time stamp that is stored in the management information table 20. Thus, the information processing apparatus 1 can reduce the number of digits of the count value of the cyclic frequency counter 16.

More specifically, the cyclic reference control unit 17 extracts, from the management information table 20 illustrated in FIG. 8, the entry that stores therein the physical block address "P0" and then compares the value of the time stamp in the extracted entry with the count value, for example, "1" of the cyclic frequency counter 16. Because the comparison result indicates that the value "2" that is obtained by adding 1 to the count value "1" of the cyclic frequency counter 16 matches the time stamp "2" in the entry that stores therein the physical block address "P0", the cyclic reference control unit 17 outputs the physical block "P0" to the data move control unit 18.

Thereafter, when the cyclic reference control unit 17 receives a response from the data move control unit 18, the cyclic reference control unit 17 extracts the entry that stores therein the physical block address "P1" from the management information table 20 and executes the determining process on the extracted entry. Furthermore, the cyclic reference control unit 17 executes the determining process on the last entry in the management information table 20. If the cyclic reference control unit 17 determines that data in the last entry is not to be moved or if the cyclic reference control unit 17 receives a response indicating that the moving of the data in the last entry has been completed, the cyclic reference control unit 17 updates the count value "1" of the cyclic frequency counter 16 to "2".

Furthermore, the cyclic reference control unit 17 may output, to the data move control unit 18 in accordance with the setting, a physical block address that indicates a block that stores therein data for an arbitrary elapsed time since the data has been written. For example, if the value of the time stamp stored in the management information table 20 is equal to or smaller than the value that is obtained by adding an arbitrary threshold "N" to the count value of the cyclic frequency counter 16, the cyclic reference control unit 17 may determine that the data is targeted for a move. The cyclic reference control unit 17 is an example of a determining unit described in the CLAIMS.

The data move control unit 18 moves data, which is stored for a predetermined elapsed time since the data has been written, to another block. That is, the data move control unit 18 moves data that is stored for a predetermined elapsed time since the data has been written. For example, when the data move control unit 18 receives a physical block address from the cyclic reference control unit 17, the data move control unit 18 outputs a move request that includes therein the received physical block address to the request arbitrating unit 13.

Furthermore, when the moving of the data has been completed, the data move control unit 18 receives a response from the request arbitrating unit 13 indicating that the moving of the data has been completed. In such a case, the data move control unit 18 outputs a response to the cyclic reference control unit 17 indicating that the moving of the data has been completed.

The requester interface unit 12, the request arbitrating unit 13, the table control unit 14, the device access control unit 15, the cyclic frequency counter 16, the cyclic reference control unit 17, and the data move control unit 18 are, for example, electronic circuits. An examples of the electronic circuit include an integrated circuit, such as an application specific integrated circuit (ASIC) and a field programmable gate array (FPGA), and a central processing unit (CPU) or a micro processing unit (MPU).

Furthermore, the table storing unit 11 is a storage device, e.g., a semiconductor memory device, such as a random access memory (RAM) or a flash memory.

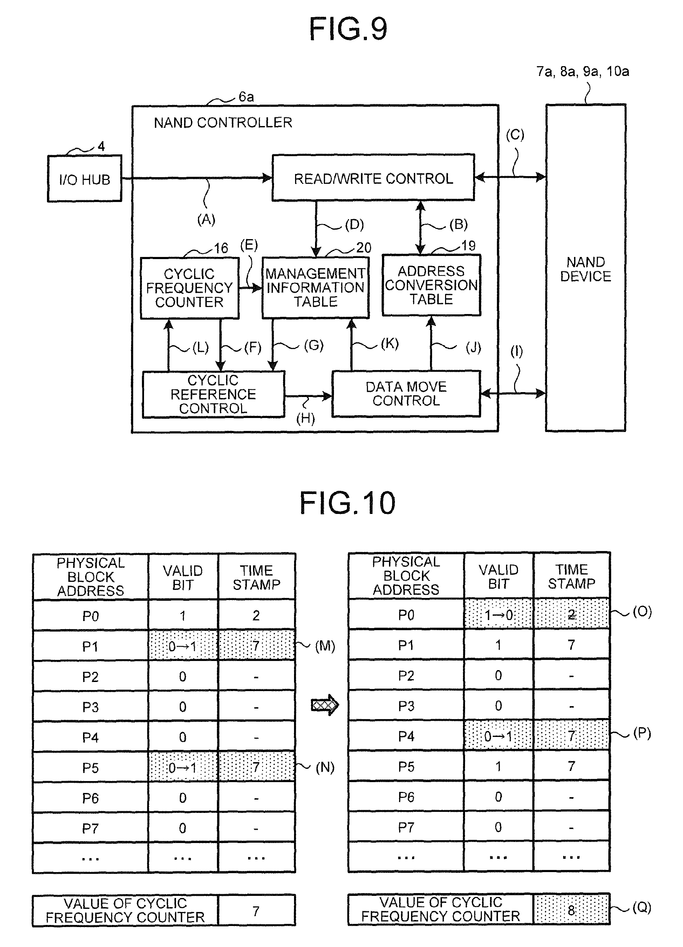

In the following, the flow of a process executed by the NAND controller 6a will be described with reference to FIG. 9. FIG. 9 is a schematic diagram illustrating a process executed by the NAND controller. For example, as illustrated by (A) in FIG. 9, when the NAND controller 6a receives a read request or a write request via the I/O hub 4, the NAND controller 6a executes read/write control. Specifically, as illustrated by (B) in FIG. 9, the NAND controller 6a refers to the address conversion table 19 and then executes address conversion between a logical address and a physical address.

Then, as illustrated by (C) in FIG. 9, the NAND controller 6a executes the reading or the writing of data with respect to the NAND devices 7a to 10a by using the converted physical address. Furthermore, as illustrated by (D) in FIG. 9, if the NAND controller 6a writes data, the NAND controller 6a updates the management information table 20. Specifically, as illustrated by (E) in FIG. 6, the NAND controller 6a stores, in the management information table 20, the count value that has been counted by the cyclic frequency counter 16 when the data has been written.

Furthermore, the NAND controller 6a executes the cyclic reference control at predetermined time intervals, or the like. Specifically, as illustrated by (F) in FIG. 9, the NAND controller 6a acquires the value of the cyclic frequency counter 16. Then, as illustrated by (G) in FIG. 9, the NAND controller 6a compares, for each entry in the management information table 20, a value of the time stamp with a value of the cyclic frequency counter 16 and then identifies a block that stores therein data that is stored for a predetermined elapsed time since the data has been written.

Then, as illustrated by (H) in FIG. 9, the NAND controller 6a executes the data move control on the identified block. For example, as illustrated by (I) in FIG. 9, the NAND controller 6a moves the data from the identified block to another block. Then, as illustrated by (J) in FIG. 9, the NAND controller 6a updates the address conversion table 19 in accordance the moving of the data and then, as illustrated by (K) in FIG. 9, the NAND controller 6a updates the management information table 20.

When the NAND controller 6a ends the process for comparing the value of the time stamp with the value of the cyclic frequency counter 16 for all of the entries in the management information table 20, as illustrated by (L) in FIG. 9, the NAND controller 6a increments the value of the cyclic frequency counter 16. Consequently, even if the number of digits of the count value of the cyclic frequency counter is small, because the count value does not exceed the value of the time stamp that is stored in the management information table 20, the NAND controller 6a can move data that is stored for a predetermined elapsed time since the data has been written.

In the following, a description will be given, with reference to FIG. 10, of an example in which the NAND controller 6a identifies, by using the management information table 20, data that is targeted for the data move control and updates the management information table 20 after the data has been moved. FIG. 10 is a schematic diagram illustrating data move control. In the example illustrated in FIG. 10, it is assumed that the number of digits of the count value of the cyclic frequency counter 16 is one.

Furthermore, in the example illustrated in FIG. 10, it is assumed, when a value of the time stamp matches a value that is obtained by adding a count value of the cyclic frequency counter 16 to "5", the NAND controller 6a moves data. Furthermore, in the example illustrated in FIG. 10, a description will be given of an example in which data in the block indicated by the physical block address "P0" is moved to the block indicated by the physical block address "P4".

For example, the NAND controller 6a stores data in the blocks indicated by the physical block addresses "P1" and "P5" when the count value of the cyclic frequency counter 16 is "7". Consequently, as illustrated by (M) in FIG. 10, the NAND controller 6a updates the valid bit in the entry that stores therein the physical block address "P1" to "1" and stores the count value "7" of the cyclic frequency counter 16 as the time stamp. Furthermore, as illustrated by (N) in FIG. 10, the NAND controller 6a updates the valid bit in the entry that stores therein the physical block address "P5" to "1" and stores the count value "7" of the cyclic frequency counter 16 as the time stamp.

At this point, the value obtained by adding "5" to the count value "7" of the cyclic frequency counter 16 is "12"; however, when taking into consideration overflow, the added value becomes "2". Consequently, as illustrated by (O) in FIG. 10, because the time stamp of the entry that stores therein the physical block address "P0" is "2", the NAND controller 6a moves the data in the block that is indicated by the physical block address "P0". Furthermore, the NAND controller 6a updates the valid bit of the entry that stores therein the physical block address "P0" to "0" and deletes the value of the time stamp.

Furthermore, as illustrated by (P) in FIG. 10, the NAND controller 6a extracts the entry that stores therein the physical block address "P4" that indicates the move destination block of the data. Then, the NAND controller 6a updates the valid bit in the extracted entry to "1" and then stores the count value "7" of the cyclic frequency counter 16 as the time stamp. Thereafter, as illustrated by (Q) in FIG. 10, the NAND controller 6a increments the count value of the cyclic frequency counter 16 by one to the count value of "8".

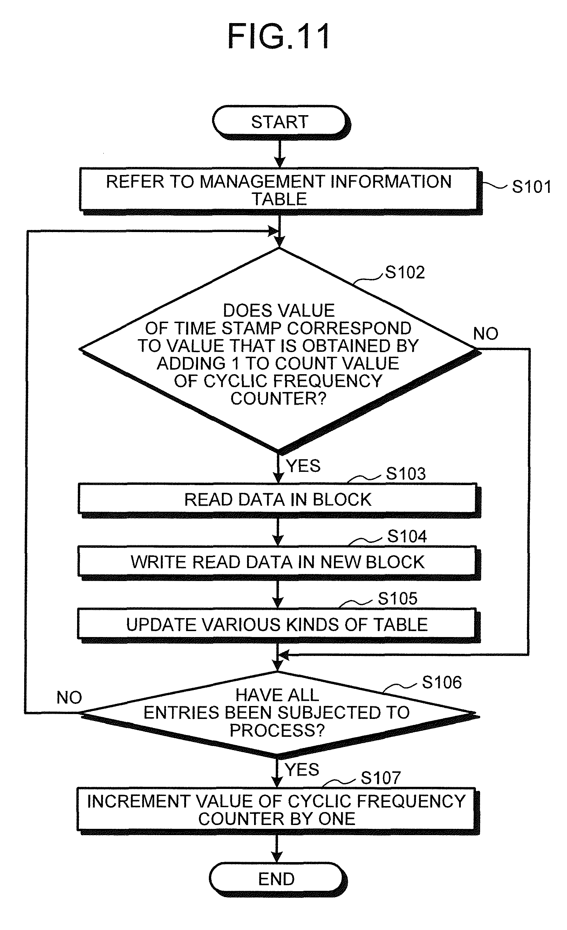

In the following, the flow of a process executed by the NAND controller 6a will be described with reference to FIG. 11. FIG. 11 is a flowchart illustrating the flow of a process executed by the NAND controller according to the first embodiment. For example, the NAND controller 6a refers to the management information table 20 (Step S101). Then, the NAND controller 6a extracts one entry from the management information table 20 that is referred to and then determines whether the value of the time stamp in the extracted entry is the value that is obtained by adding 1 to the count value of the cyclic frequency counter 16 (Step S102).

If the NAND controller 6a determines that the value of the time stamp is the value that is obtained by adding 1 to the count value of the cyclic frequency counter 16 (Yes at Step S102), the NAND controller 6a executes the data move control indicated by Steps S103 to S105. Specifically, the NAND controller 6a reads data in the block that is indicated by the physical block address stored in the extracted entry (Step S103). Then, the NAND controller 6a writes the read data in a new block (Step S104).

Then, the NAND controller 6a updates the address conversion table 19 and the management information table 20 in accordance with the moving of the data (Step S105). The processes at Steps S103 to S105 are executed, in an atomic manner, by the request arbitrating unit 13 and the table control unit 14. In contrast, when the NAND controller 6a determines that the value of the time stamp is not the value that is obtained by adding 1 to the count value of the cyclic frequency counter 16 (No at Step S102), the NAND controller 6a skips the data move control indicated by Steps S103 to S105.

Furthermore, the NAND controller 6a determines whether the processes at Steps S102 to S105 have been executed on all of the entries in the management information table 20 (Step S106). If the NAND controller 6a determines that the processes at Steps S102 to S105 have not been executed on all of the entries in the management information table 20 (No at Step S106), the NAND controller 6a executes the following process. Namely, the NAND controller 6a again executes the process at Step S102 for the entries that have not been subjected to the process at Step S102 from among the entries in the management information table 20.

Furthermore, if the NAND controller 6a determines that the processes at Steps S102 to S105 have been executed on all of the entries in the management information table 20 (Yes at Step S106), the NAND controller 6a executes the following process. Namely, the NAND controller 6a increments the value of the cyclic frequency counter 16 by one (Step S107) and then ends the process.

### Advantage of information processing apparatus 1

As described above, if the process of determining whether data stored in the NAND devices 7a to 10a is targeted for a move is executed on all pieces of data, the information processing apparatus 1 updates the count value of the cyclic frequency counter 16. Furthermore, when data is written in the NAND devices 7a to 10a, the information processing apparatus 1 stores the count value of the cyclic frequency counter 16 by associating the count value with a physical block address that indicates the block in which the data is to be written. Then, the information processing apparatus 1 compares, for each data, the stored count value that is associated with the physical block address in which the data has been written with the count value of the cyclic frequency counter 16 and determines whether the data in each block is targeted for a move.

Consequently, even if the number of digits of the count value of the cyclic frequency counter 16 is small, the information processing apparatus 1 can prevent a state in which a count value of the cyclic frequency counter 16 exceeds the value of the time stamp stored in the management information table 20. Consequently, the information processing apparatus 1 can reduce the number of digits of the time stamp. Furthermore, because the storage capacity of the table storing unit 11 can be reduced, the size of the circuit for the NAND controller 6a can be reduced. Furthermore, because the size of the management information table 20 can be reduced, the information processing apparatus 1 can reduce the time taken to execute the search process and thus can improve the accessibility with respect to the NAND devices 7a to 10a.

Furthermore, the information processing apparatus 1 stores, in an associated manner in the management information table 20, a physical block address and the time stamp, which is the count value obtained when data is written in the block indicated by the physical block address. Then, the information processing apparatus 1 compares, for each physical block address, the count value of the cyclic frequency counter 16 with the value of the time stamp stored in the management information table 20 and determines whether the each piece of data is to be rewritten in the NAND devices 7a to 10a.

Consequently, the information processing apparatus 1 can detects, for each block, data that is stored for a predetermined elapsed time since the data has been written. Consequently, the information processing apparatus 1 can perform, for each block in the NAND devices 7a to 10a, the leveling of the degradation on elements and thus can prevent bits from being garbled due to discharge of a portion of an element.

Furthermore, the information processing apparatus 1 returns the count value of the cyclic frequency counter 16 to the initial value with a predetermined value. If the value that is obtained by adding 1 to the count value matches the value of the time stamp for a piece of data stored in the management information table 20, the information processing apparatus 1 determines that the data is targeted for a move. Consequently, the information processing apparatus 1 can move the oldest data from among the pieces of data stored in the NAND devices 7a to 10a.

### [b] Second Embodiment

The NAND controller 6a described above determines, for all of the physical block addresses by executing a single cyclic reference control, whether data is to be moved; however, the embodiment is not limited thereto. For example, a NAND controller 6c according to a second embodiment may also execute the determining process on only some of the physical block addresses from among all of the physical block addresses when a single cyclic reference process is executed.

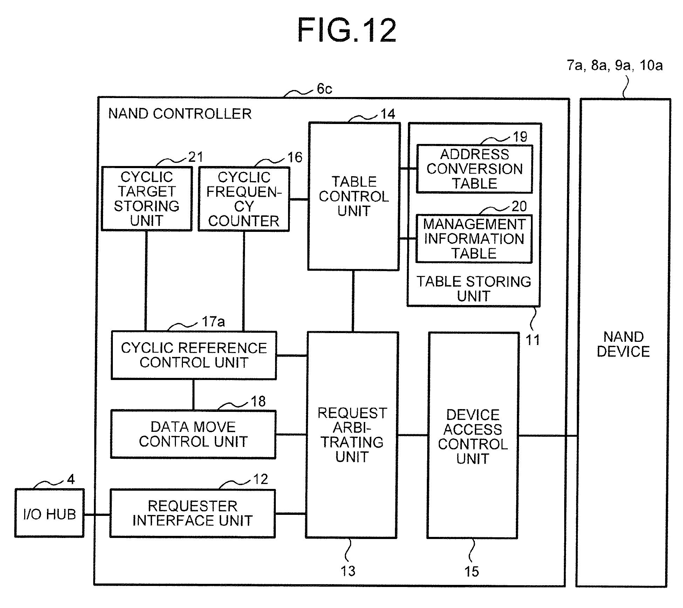

In the following, a process executed by the NAND controller 6c will be described. At first, the functional configuration of the NAND controller 6c will be described with reference to FIG. 12. FIG. 12 is a schematic diagram illustrating the functional configuration of a NAND controller according to a second embodiment. The functional configurations in the NAND controller 6c illustrated in FIG. 12 having the same function as those of the functional configurations in the NAND controller 6a illustrated in FIG. 6 are assigned the same reference numerals; therefore, descriptions thereof will be omitted.

In the example illustrated in FIG. 12, the NAND controller 6c includes a cyclic reference control unit 17a and a cyclic target storing unit 21. The cyclic target storing unit 21 is a memory that stores therein the target that has been subjected to the determining process by the cyclic reference control unit 17a. The cyclic reference control unit 17a has the same function as that performed by the cyclic reference control unit 17 illustrated in FIG. 6 and executes cyclic reference control at predetermined time intervals.

At this point, the cyclic reference control unit 17a sequentially executes the determining process on the entries in the management information table 20 starting from the entry that stores therein the physical block address of "P0". For example, the cyclic reference control unit 17a extracts the entry that stores therein the physical block address "P0"; compares the value of the time stamp of the extracted entry with the count value of the cyclic frequency counter 16; and executes the determining process. Then, the cyclic reference control unit 17a extracts the entry that stores therein the physical block address of "P1" and executes the determining process on the extracted entry.

At this point, if a predetermined time has elapsed since the cyclic reference control is started, the cyclic reference control unit 17a stores, in the cyclic target storing unit 21, the physical block address that is stored in the entry that is immediately previously subjected to the determining process. Thereafter, when the cyclic reference process is resumed, the cyclic reference control unit 17a sequentially executes the determining process on the entries starting from the entry that stores therein the physical block address subsequent to the physical block address that has been stored in the cyclic target storing unit 21. Thereafter, if the determining process is performed on all of the entries in the management information table 20, the cyclic reference control unit 17a increments the value of the cyclic frequency counter 16 by one.

For example, if a predetermined time has elapsed when the determining process has been completed on the entry that stores therein the physical block address "P7", the cyclic reference control unit 17a stores the physical block address "P7" in the cyclic target storing unit 21. In such a case, when the cyclic reference control unit 17a resumes the cyclic reference control, the cyclic reference control unit 17a acquires the physical block address "P7" from the cyclic target storing unit 21. Then, the cyclic reference control unit 17a extracts, from the management information table 20, the entry that stores therein the physical block address "P8" that is subsequent to the physical block address "P7" and then executes the determining process on the extracted entry.

Instead of grouping the determination targets in a predetermined time period, the cyclic reference control unit 17a may also group the determination targets by using another method. For example, the cyclic reference control unit 17a may group the physical block addresses for each predetermined number. Then, the cyclic reference control unit 17a may also execute the determining process on the physical block addresses included in a single group when a single cyclic reference control is executed.

For example, the cyclic reference control unit 17a uses the physical block addresses "P0" to "P7" as a group "No. 1" and uses the physical block addresses "P8" to "P15" as a group "No. 2". That is, for values of higher-order bits used for the physical block addresses, the cyclic reference control unit 17a defines the eight consecutive physical block addresses as a single group. Then, from among the entries in the management information table 20, the cyclic reference control unit 17a executes the determining process on entries that store therein the physical block addresses included in the group "No. 1".

Furthermore, when the cyclic reference control unit 17a executes the determining process on each entry that stores therein one of the physical block addresses in the group "No. 1", the cyclic reference control unit 17a stores, in the cyclic target storing unit 21, the group "No. 1" as information that indicates the group that has been subjected to the determining process. Then, when the cyclic reference control is resumed, the cyclic reference control unit 17a acquires the information "No. 1" that indicates the group from the cyclic target storing unit 21. In such a case, the cyclic reference control unit 17a executes the determining process on each of the entries, in the management information table 20, that stores therein the physical block addresses in the group "No. 2" that is subsequent to the group "No. 1".

The cyclic reference control unit 17a may use arbitrary information as information that indicates a group. For example, when the cyclic reference control unit 17a groups the physical block addresses by using higher-order bits, the cyclic reference control unit 17a may also store, in the cyclic target storing unit 21, the higher-order bits for the physical block addresses in a group that has been subjected to the determining process.

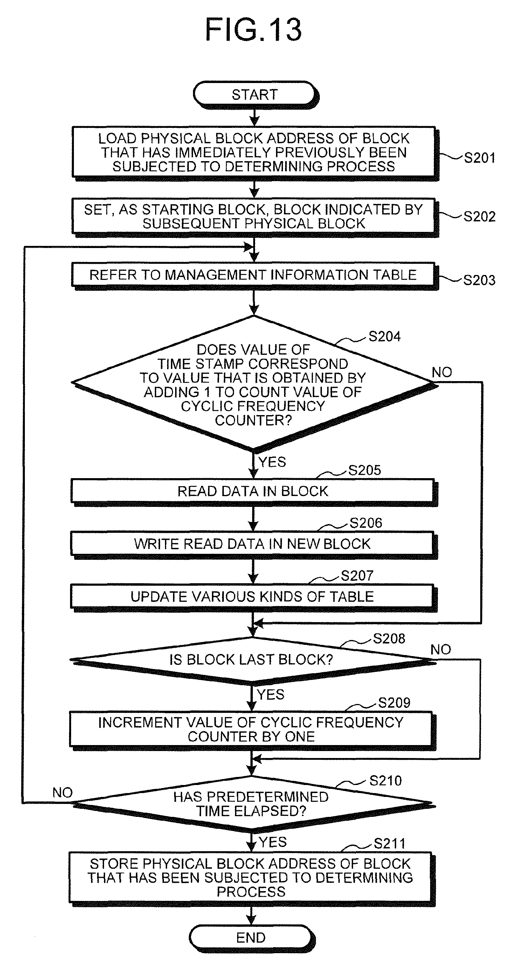

In the following, the flow of a process executed by the NAND controller 6c will be described with reference to FIG. 13. FIG. 13 is a flowchart (No. 1) illustrating the flow of a process executed by the NAND controller according to the second embodiment. FIG. 13 illustrates an example in which the NAND controller 6c groups the blocks targeted for determination within a predetermined time period. Furthermore, from among the processes illustrated in FIG. 13, it is assumed that the processes executed at Steps S203 to S207 are the same as those executed at Steps S101 to S105 illustrated in FIG. 11; therefore, descriptions thereof will be omitted.

Firstly, the NAND controller 6c reads, from the cyclic target storing unit 21, a physical block address that indicates the block that has immediately previously been subjected to determining process (Step S201). Then, the NAND controller 6c sets, as the starting block, the block indicated by the physical block address that is subsequent to the physical block address that has been read (Step S202). Then, the NAND controller 6c executes the processes at Steps S203 to S207.

Furthermore, after the NAND controller 6c executes the process at Step S207, the NAND controller 6c determines whether the block indicated by the physical block address that is targeted for the determination is the last block (Step S208). Then, if the NAND controller 6c determines that the block indicated by the physical block address that is targeted for the determination is the last block (Yes at Step S208), the NAND controller 6c increments the count value of the cyclic frequency counter 16 by one (Step S209). In contrast, if the NAND controller 6c determines that the block indicated by the physical block address that is targeted for the determination is not the last block (No at Step S208), the NAND controller 6c skips the process at Step S209.

Then, the NAND controller 6c determines whether a predetermined time has elapsed since the starting of the cyclic reference process (Step S210). If the NAND controller 6c determines that a predetermined time has elapsed since the starting of the cyclic reference process (Yes at Step S210), the NAND controller 6c stores, in the cyclic target storing unit 21, the physical block address that indicates the block that has been subjected to the determining process (Step S211) and then ends the process. In contrast, if the NAND controller 6c determines that a predetermined time has not elapsed since the starting of the cyclic reference process (No at Step S210), the NAND controller 6c executes the process at Step S203.

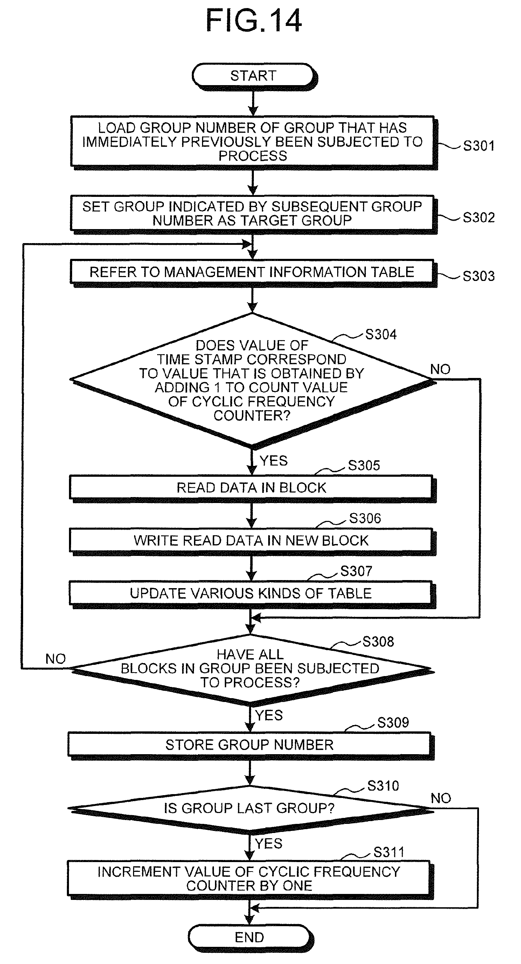

In the following, the flow of another process executed by the NAND controller 6c will be described with reference to FIG. 14. FIG. 14 is a flowchart (No. 2) illustrating the flow of a process executed by the NAND controller according to the second embodiment. FIG. 14 illustrates an example in which the NAND controller 6c groups the physical block addresses for each number of physical block addresses and the blocks included in a single group are targeted for the determining process when a single cyclic reference control is executed. Furthermore, from among the processes illustrated in FIG. 14, it is assumed that the determining processes executed at Steps S303 to S307 are the same as those executed at Steps S101 to S105 illustrated in FIG. 11; therefore, descriptions thereof will be omitted.

Firstly, the NAND controller 6c reads, from the cyclic target storing unit 21, the group number of the group that has immediately previously been subjected to the determining process (Step S301). Then, the NAND controller 6c sets the group indicated by the group number that is subsequent to the read group number as the target for the cyclic reference process (Step S302). Then, the NAND controller 6c executes the processes at Steps S303 to S307 on each of the blocks included in the group that is to be subjected to the cyclic reference process.

Furthermore, after executing the process at Step S307, the NAND controller 6c determines whether the block indicated by the physical block address that is targeted for determination is the last block in the group that is targeted for the cyclic reference process (Step S308). If the NAND controller 6c determines that the block indicated by the physical block address targeted for determination is the last block in the group that is targeted for the cyclic reference process (Yes at Step S308), the NAND controller 6c executes the following process. Namely, the NAND controller 6c stores, in the cyclic target storing unit 21, the group number of the group that is targeted for the cyclic reference process (Step S309).

Furthermore, the NAND controller 6c determines whether the group that has been subjected to the cyclic reference process is the last group (Step S310). That is, the NAND controller 6c determines whether the determining process has been executed on all of the entries in the management information table 20. If the NAND controller 6c determines that the group subjected to the cyclic reference process is the last group (Yes at Step S310), the NAND controller 6c increments the count value of the cyclic frequency counter 16 by one (Step S311) and then ends the process.

In contrast, if the NAND controller 6c determines that the group subjected to the cyclic reference process is not the last group (No at Step S310), the NAND controller 6c skips the process at Step S311 and then ends the process. Furthermore, if the NAND controller 6c determines that the block indicated by the physical block address that is targeted for the determination is not the last block in the group targeted for the cyclic reference process (No at Step S308), the NAND controller 6c executes the process at Step S303.

### Advantage of the NAND controller 6c

As described above, if a predetermined time has elapsed since the starting of the cyclic reference control, the NAND controller 6c stores the physical block address that indicates the block that is immediately previously targeted for the determining process. Thereafter, when the cyclic reference process is resumed, the NAND controller 6c executes the cyclic reference process on the blocks, in the order of the physical block addresses, starting from the block indicated by the physical block address that is subsequent to the stored physical block address.

Consequently, the NAND controller 6c can reduce the processing time taken to execute the cyclic reference process once. Thus, the NAND controller 6c can implement flexible scheduling, e.g., the cyclic reference process is executed in the night at which the information processing apparatus 1 does not execute processes. Furthermore, because the NAND controller 6c reduces an inaccessible time to the NAND devices 7a to 10a due to the cyclic reference process, the accessibility to the NAND devices 7a to 10a can be improved.

Furthermore, the NAND controller 6c divides the storage area of each of the NAND devices 7a to 10a into multiple groups and executes the cyclic reference process for each group. Consequently, the NAND controller 6c reduces the processing time at which the cyclic reference process is executed once and flexible scheduling can be implemented. Furthermore, the NAND controller 6c can improve the accessibility with respect to the NAND devices 7a to 10a.

### [c] Third Embodiment

If the value obtained by adding a predetermined threshold to the count value of the cyclic frequency counter 16 matches the value of the time stamp, the NAND controllers 6a to 6c described above execute the process of moving data; however, the embodiment is not limited thereto. For example, the NAND controllers 6a to 6c may also dynamically set a threshold in accordance with the number of requests issued for each block.

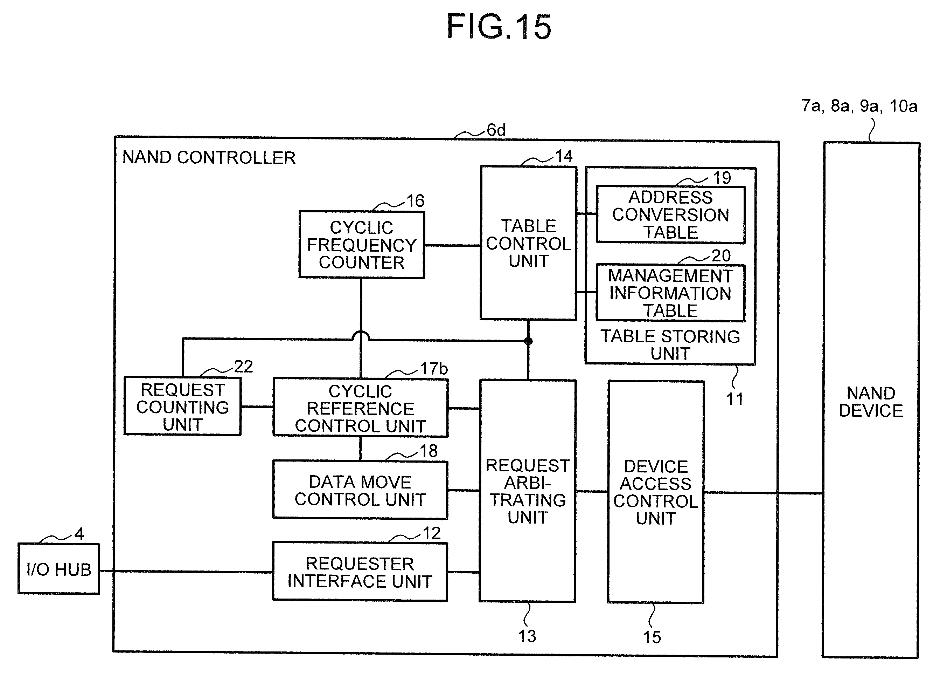

In the following, a description will be given of a NAND controller 6d, as a NAND controller according to a third embodiment, that sets different thresholds in accordance with the number of requests issued for each block. At first, the functional configuration of the NAND controller 6d will be described with reference to FIG. 15. FIG. 15 is a schematic diagram illustrating the functional configuration of a NAND controller according to a third embodiment. The functional configurations in the NAND controller 6d illustrated in FIG. 15 having the same function as those of the functional configurations in the NAND controller 6a illustrated in FIG. 6 are assigned the same reference numerals; therefore, descriptions thereof will be omitted.

For example, the NAND controller 6d includes a cyclic reference control unit 17b and a request counting unit 22. The request counting unit 22 executes, for each block included in the NAND devices 7a to 10a, the following process. Firstly, the request counting unit 22 monitors a signal line or a bus that connects the request arbitrating unit 13 to the table control unit 14 and counts the number of requests issued to each block. Specifically, the request counting unit 22 measures, for each block at predetermined time intervals, the number of requests issued to each block, e.g., the number of read requests or write requests issued to each block.

The request counting unit 22 may also count one of the read request and the write request. Furthermore, by monitoring the signal line or the bus that connects the request arbitrating unit 13 to the device access control unit 15, the request counting unit 22 may also count the number of requests for each block.

Furthermore, the request counting unit 22 calculates, for each block from the counting result, the average request issue count that is the average value of the requests issued for 10 seconds. Then, the request counting unit 22 sets, for each block, a threshold in accordance with the calculated average request issue count. Thereafter, the request counting unit 22 outputs the threshold that is set for each block to the cyclic reference control unit 17b. The request counting unit 22 is an example of a request counting unit and a setting unit described in the CLAIMS.

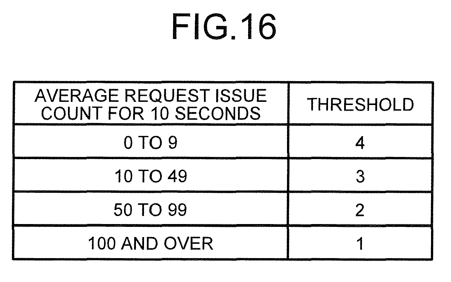

In the following, an example of a threshold that is set, by the request counting unit 22, in accordance with the average request issue count will be described with reference to FIG. 16. FIG. 16 is a schematic diagram illustrating an example of thresholds according to an average request issue count. For example, as illustrated in FIG. 16, the request counting unit 22 sets the threshold for the blocks, in which the average request issue count is between "0" and "9", to "4" and sets the threshold for the blocks, in which the average request issue count is between "10" and "49", to "3".

Furthermore, the request counting unit 22 sets the threshold for the blocks, in which the average request issue count is between "50" and "99", to "2" and sets the threshold for the blocks, in which the average request issue count is equal to or greater than "100", to "1". The average request issue counts associated with the thresholds illustrated in FIG. 16 are only examples. The NAND controller 6d can set an arbitrary threshold as long as the NAND controller 6d sets a threshold in accordance with the number of average request issue counts.

A description will be given here by referring back to FIG. 15. The cyclic reference control unit 17b has the same function as that executed by the cyclic reference control unit 17 illustrated in FIG. 6. Furthermore, when the cyclic reference control unit 17b executes the determining process on each of the entries in the management information table 20, the cyclic reference control unit 17b executes the following process. Firstly, the cyclic reference control unit 17b extracts an entry that is targeted for the determining process from the management information table 20.

Furthermore, the cyclic reference control unit 17b calculates the sum of the count value of the current cyclic frequency counter 16 and the threshold that is set, by the request counting unit 22, to a block that is indicated by the physical block address stored in the extracted entry. Then, the cyclic reference control unit 17b determines whether the value of the time stamp stored in the extracted entry is equal to or less than the calculated sum.

If the value of the time stamp stored in the extracted entry is equal to or less than the calculated sum, the cyclic reference control unit 17b outputs the physical block address stored in the extracted entry to the data move control unit 18 and then moves the data. In contrast, if the value of the time stamp stored in the extracted entry is greater than the calculated sum, the cyclic reference control unit 17b executes, without moving the data, the determining process on the subsequent entry in the management information table 20.

Consequently, for a block to which a read request or a write request is frequently issued, the NAND controller 6d postpones the moving of data; therefore, a read request or a write request is executed without being hindered. Consequently, it is possible to prevent the accessibility from worsening. In contrast, for the block to which a read request or a write request is not frequently issued, the NAND controller 6d executes the moving of data ahead of schedule. Consequently, it is possible to prevent bits from being garbled while preventing the accessibility from worsening.

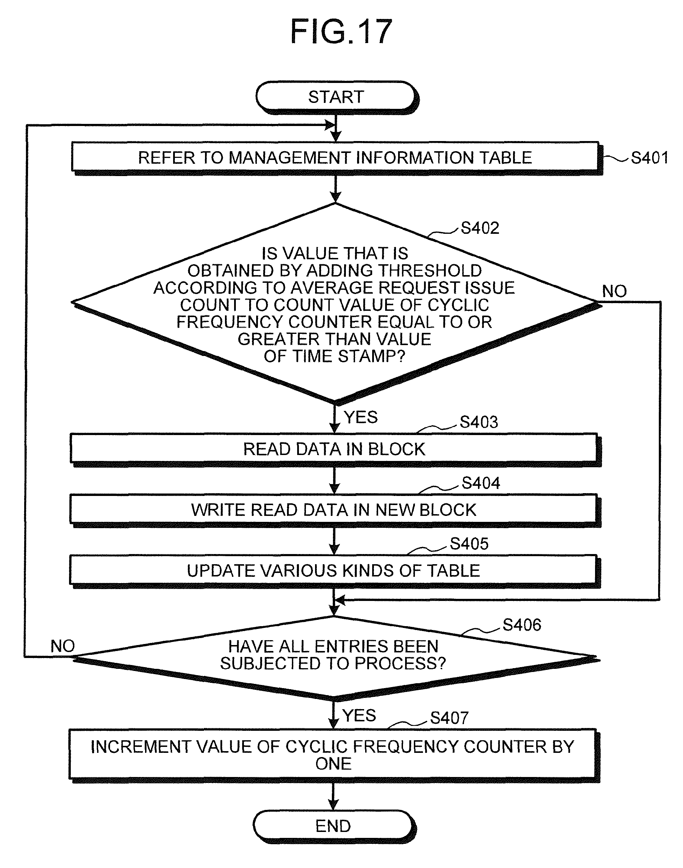

In the following, another example of a process executed by the NAND controller 6d will be described with reference to FIG. 17. FIG. 17 is a flowchart illustrating the flow of a process executed by the NAND controller according to the third embodiment. It is assumed that the processes executed at Step S401 and Steps S403 to S407 illustrated in FIG. 17 are the same determining process as those executed at Step S101 and Steps S103 to S107 illustrated in FIG. 11; therefore, descriptions thereof will be omitted.

For example, for the entry targeted for the determining process, the NAND controller 6d determines whether the value that is obtained by adding the threshold according to the average request issue count to the count value of the cyclic frequency counter 16 is equal to or greater than the value of the time stamp (Step S402). If the value that is obtained by adding the threshold according to the average request issue count to the count value of the cyclic frequency counter 16 is equal to or greater than the value of the time stamp (Yes at Step S402), the NAND controller 6d executes the process at Step S403. In contrast, the value that is obtained by adding the threshold according to the average request issue count to the count value of the cyclic frequency counter 16 is less than the value of the time stamp (No at Step S402), the NAND controller 6d executes the process at Step S406.

### Advantage of the NAND controller 6d

As described above, the NAND controller 6d counts, for each block, the number of the read requests and the write requests that are issued. Furthermore, the NAND controller 6d sets, for each block and in accordance with the number of the counted requests, a threshold that is used to determine whether data in each block is to be moved, i.e., a threshold that is used to determine whether data in each block is targeted for a move.

Then, the NAND controller 6d calculates, for each block, the sum of the count value of the cyclic frequency counter 16 and the set threshold and then determines whether the calculated value is equal to or greater than the value of the time stamp stored in the management information table 20. Thereafter, if the calculated value is equal to or greater than the value of the time stamp stored in the management information table 20, the NAND controller 6d determines that the data stored in the block that is targeted for the determination is targeted for a move.

Consequently, the NAND controller 6d can move data in accordance with the number of requests issued by each of the CPUs 3a and 3b. For example, for a block to which a read request or a write request is frequently issued, the NAND controller 6d postpones the moving of data. For example, for a block to which a read request or a write request is not frequently issued, the NAND controller 6d moves data ahead of schedule. Consequently, the NAND controller 6d can prevent the accessibility from worsening or can prevent bits from being garbled.

### [d] Fourth Embodiment

In the above explanation, a description has been given of the embodiments; however, the embodiments are not limited thereto and can be implemented with various kinds of embodiments other than the embodiments described above. Therefore, another embodiment will be described as a fourth embodiment below.

### (1) Granularity of moving of data

The NAND controllers 6a to 6d described above determine, for each block in the NAND devices 7a to 10a, whether data is to be moved; however, the embodiment is not limited thereto. Specifically, the NAND controllers 6a to 6d may determine whether data is to be moved in an arbitrary unit. For example, the NAND controllers 6a to 6d may also determine whether, for multiple blocks, data is to be moved. Furthermore, the NAND controllers 6a to 6d may also use different granularity, such as in units in which the management information table 20 manages a time stamp and in units in which data is written.

### (2) Functional configuration of the NAND controllers 6a to 6d

The functional configurations of the NAND controllers 6a to 6d described above are only examples. Any configuration may also be used as long as the same processes executed by the NAND controllers 6a to 6d can be executed. For example, the NAND controller 6a may also include a move control unit that has the function executed by both the cyclic reference control unit 17 and the data move control unit 18.

The description has been given, in the examples described above, of a process in which each of the NAND controllers 6a to 6d determine whether data stored in the NAND devices 7a to 10a is targeted for a move; however, the embodiment is not limited thereto. Specifically, the NAND controllers 6a to 6d may also operate as a memory controller for a storage medium, such as a memory, that uses an arbitrary technology, as long as data is moved.

### (3) Arbitrate a request

The NAND controllers 6a to 6d described above execute, with priority, a read request or a write request received from the requester interface unit 12; however, the embodiment is not limited thereto. For example, the NAND controllers 6a to 6d may also arbitrate each request such that the life of cells in the NAND devices 7a to 10a are leveled.

### (4) Spare block

The table control unit 14 described above uses a spare block, in which no data is stored, as the move destination for data; however, the embodiment is not limited thereto. For example, the table control unit 14 may identify a block having the longest life expectancy from the blocks in which no data is stored. Then, the table control unit 14 may notify the request arbitrating unit 13 of the physical block address that indicates the identified block. If this process is executed, each of the NAND controllers 6a to 6d can level the degradation of cells in blocks in the NAND devices 7a to 10a and can use up the life of each block.

### (5) Cyclic frequency counter

Each of the NAND controllers 6a to 6d described above includes the cyclic frequency counter 16 that counts from "0" to "9"; however, the embodiment is not limited thereto. Specifically, an arbitrary range or number of digits may be set to the value counted by the cyclic frequency counter 16. For example, each of the NAND controllers 6a to 6d may include the cyclic frequency counter 16 that counts "0" or "1" and then all pieces of data may be moved in a time period for which the cyclic reference control is executed twice.

Furthermore, each of the NAND controllers 6a to 6d does not need to include a counter as the cyclic frequency counter 16. For example, each of the NAND controllers 6a to 6d may include a memory that stores therein a value with a predetermined number of digits and then may store a count value in the memory. When one of the NAND controllers 6a to 6d has executed the determining process on all of the entries in the management information table 20, the one of the NAND controllers 6a to 6d may read a count value in the memory and may rewrite a value obtained by adding 1 to the read value, whereby the cyclic frequency counter 16 may also be reconstructed.

Furthermore, the NAND controllers 6a to 6d may store, in an arbitrary storage device, the number of times the cyclic reference control has been executed and then may update, after the cyclic reference control has been executed, the number of times stored in the storage device, whereby the function executed by the cyclic frequency counter 16 may also be implemented.

Furthermore, the NAND controllers 6a to 6d may store, in the management information table 20 for each block, a write bit that indicates whether data is written after the cyclic reference control has been executed. Then, the NAND controllers 6a to 6d may refer to the write bit in the management information table 20 and may identify a block in which data is not written after the cyclic reference control has been executed. Thereafter, the NAND controllers 6a to 6d may also move the data in the identified block and then may reset the flag in the management information table 20.

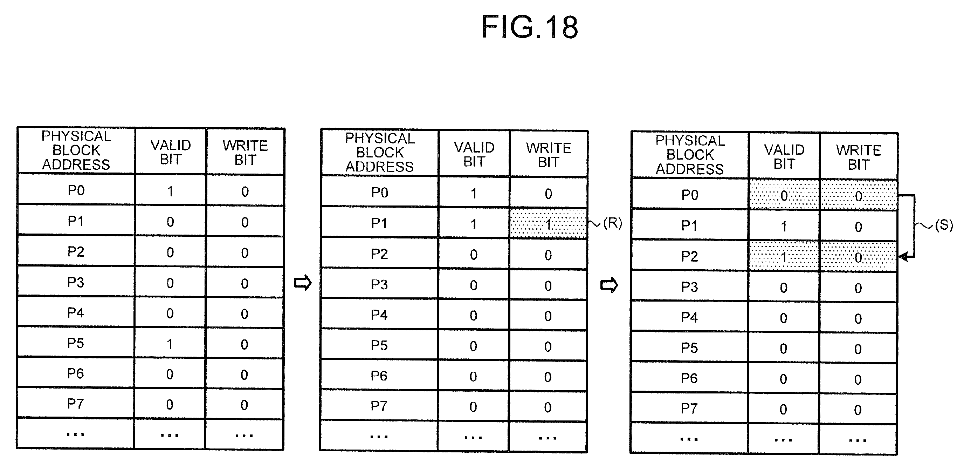

Namely, for the block in which no data is written since the immediately previous cyclic reference process has been executed, if one of the NAND controllers 6a to 6d rewrites data, the one of the NAND controllers 6a to 6d may also execute the process by using a write bit without including the cyclic frequency counter 16. In the following, an example of the cyclic reference process executed by the NAND controller 6a without including the cyclic frequency counter 16 will be described with reference to FIG. 18.

FIG. 18 is a schematic diagram illustrating an example of a process executed by using a write bit. FIG. 18 illustrates an example of information that is stored in the management information table 20 when the NAND controller 6a executes the cyclic reference process without using the cyclic frequency counter 16. As illustrated in FIG. 18, the NAND controller 6a stores, in the management information table 20, a write bit instead of a time stamp. The write bit mentioned here means information that indicates whether data is written or moved since immediately previous cyclic reference process has been executed.

For example, in the example illustrated in FIG. 18, in the management information table 20, data is stored in the blocks indicated by the physical block addresses "P0" and "P5". At this point, as the result of the updating or the moving of data, the NAND controller 6a moves the data that is stored in the block indicated by the physical block address "P5" to the block indicated by the physical block address "P1".

Then, from among the entries in the management information table 20, the NAND controller 6a updates the valid bit associated with the physical block address "P5" to "0" and updates the valid bit associated with the physical block address "P1" to "1". Furthermore, as illustrated by (R) in FIG. 18, the NAND controller 6a updates the write bit associated with the physical block address "P1" to "1".

At this point, if the NAND controller 6a executes the cyclic reference process, the NAND controller 6a executes the following process. Firstly, the NAND controller 6a identifies, from among the entries in the management information table 20, an entry in which the valid bit is "1" and the write bit is "0". Namely, the NAND controller 6a identifies a physical block address that indicates the block in which the writing or the moving of data is executed after the immediately previous cyclic reference process has been executed. Then, the NAND controller 6a moves the data in the block indicated by the identified physical block address to another block.

For example, from the management information table 20 illustrated in FIG. 18, the NAND controller 6a identifies the physical block address "P0" that is stored in the entry in which the valid bit is "1" and the write bit is "0". Then, as illustrated by (S) in FIG. 18, the NAND controller 6a moves data in the block indicated by the physical block address "P0" to the block indicated by the physical block address "P2" and then updates the management information table 20. Furthermore, for all of the entries in the management information table 20, the NAND controller 6a executes the process described above. If the process has been executed on all of the entries, all of the write bits stored in the management information table 20 are reset to "0".

Consequently, because the NAND controller 6a can move data, without using a counter, that is stored for a predetermined elapsed time since the data has been written, the amount of data stored in the management information table 20 can be reduced. Furthermore, if the NAND controller 6a updates the value of the write bit to "1" when data is moved and if the process has been executed on all of the entries, the NAND controller 6a does not need to reset all of the write bits stored in the management information table 20 to "0". In such a case, the NAND controller 6a may reset the write bits at an arbitrary timing.

### (6) Granularity of the counting of the number of requests

With the NAND controller 6d described above, the request counting unit 22 counts, for each block, the number of requests issued to each of the blocks and sets a threshold for each block; however, the embodiment is not limited thereto. For example, the NAND controller 6d may also count the number of requests and set a threshold by using different granularity. For example, the NAND controller 6d may also count the number of requests issued to all of the blocks by using a shared counter and may also set a single threshold shared by the entirety of the NAND controller 6d. Furthermore, the NAND controller 6d may also set, for each group that includes multiple blocks, a threshold in accordance with the number of issued requests.

As described above, if the NAND controller 6d sets, in accordance with the number of requests issued to all of the blocks, a threshold that is used to determine whether data is moved, e.g., if a read request or a write request is frequently issued, the NAND controller 6d can postpone the moving of the data. Furthermore, if a read request or a write request is not frequently issued, the NAND controller 6d can move data ahead of schedule. Consequently, the NAND controller 6d can prevent the accessibility from worsening or prevent bits from being garbled.

### (7) Program

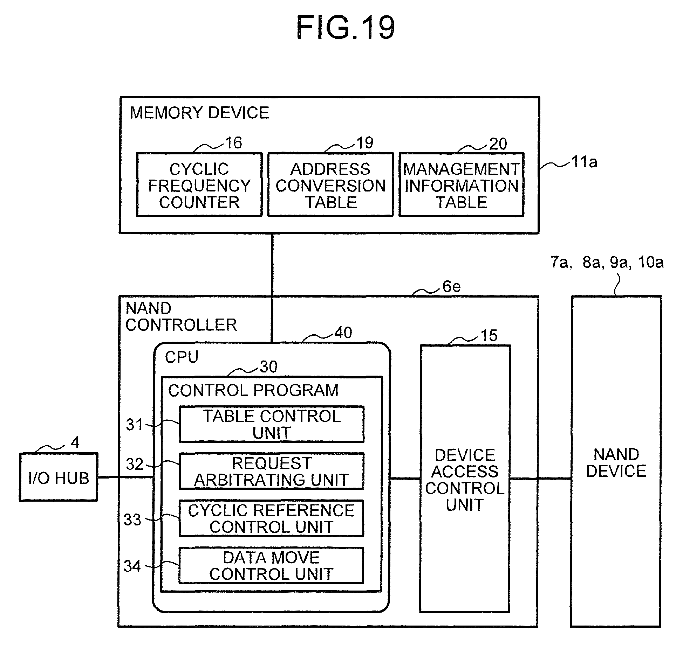

The functions executed by the NAND controllers 6a to 6d described in the above embodiments may also be implemented by a control program prepared in advance and executed by an arithmetic processing unit in the NAND controller. Accordingly, in the following, an example of a computer that executes a control program having the same function as that executed by the NAND controller 6a will be described with reference to FIG. 19.

FIG. 19 is a schematic diagram illustrating an example of a NAND controller that executes a control program. As illustrated in FIG. 19, the NAND controller 6e includes a CPU 40 and the device access control unit 15. The CPU 40 is connected to a memory device 11a. The memory device 11a may be a memory installed inside the NAND controller 6e.

The memory device 11a stores therein, in advance, the cyclic frequency counter 16, the address conversion table 19, and the management information table 20. At this point, the CPU 40 reads a control program 30, loads and executes the control program 30, and thus the control program 30 functions as follows. Namely, the control program 30 operates the CPU 40 as a table control unit 31, a request arbitrating unit 32, a cyclic reference control unit 33, and a data move control unit 34, whereby the table control unit 31, the request arbitrating unit 32, the cyclic reference control unit 33, and the data move control unit 34 execute the same functions as those executed by the table control unit 14, the request arbitrating unit 13, the cyclic reference control unit 17, and the data move control unit 18, respectively, illustrated in FIG. 6.

The control program 30 described above allows the CPU 40 to store, in the memory device 11a, the number of times the cyclic reference control is executed as the cyclic frequency counter 16. Then, if the control program 30 has allowed the CPU 40 to execute the cyclic reference control on all of the blocks, the value of the cyclic frequency counter 16 is updated. Furthermore, the NAND controller 6e may also execute the control program 30, instead of using a CPU, by using an arithmetic device, such as an MPU, an FPGA, or the like.

Furthermore, the control program 30 described above may also be stored in, for example, the memory device 11a or the NAND devices 7a to 10a or may also be executed by the CPU 40 by using another method. For example, each of the program is stored in a "portable physical medium", such as a flexible disk (FD), a compact disk (CD)-ROM, a digital versatile disk (DVD), a magneto-optical disk, an IC CARD, or the like.

Then, the NAND controller 6e may acquire each of the programs from these portable physical medium via the CPU 40 and may execute each of the programs. Furthermore, the NAND controller 6e may acquire each of the programs stored in another computer or a server device via a public circuit, the Internet, a LAN, a wide area network (WAN), or the like, and may execute each of the programs.

According to an aspect of an embodiment of the present invention, an advantage is provided in that it is possible to reduce the amount of information that indicates the time at which data is written.

## Claims

1. An information processing apparatus (1) comprising:
a storage device (7a to 10a);
a counting unit (16) that updates a count value when a process that determines whether data stored in each of multiple storage areas included in the storage device (7a to 10a) is targeted for a move has been executed on all pieces of the data stored in the storage device (7a to 10a);
a count value storing unit (11) that stores therein, when the data is written in the storage device (7a to 10a), the count value of the counting unit (16) associated with the data; and
a determining unit (17) that compares, for each data stored in the storage device (7a to 10a), a value stored in the count value storing unit (11) with the count value of the counting unit (16) and that determines whether each piece of the data is targeted for a move.

2. The information processing apparatus (1) according to claim 1, wherein
the count value storing unit (11) stores therein, in an associated manner, an area identifier that is used to identify the storage areas and the count value of the counting unit (16) associated with the data, when the data is written in a storage area indicated by the area identifier, and
the determining unit (17) compares, for each area identifier, a value stored in the count value storing unit (11) with the count value of the counting unit (16) and determines whether the data stored in the storage area indicated by the area identifier is targeted for a move.

3. The information processing apparatus (1) according to claim 1 or 2, wherein when a predetermined time has elapsed since the starting of the process that determines whether each piece of the data stored in the storage device (7a to 10a) is targeted for a move, the determining unit (17) stores an area identifier that indicates the storage area in which the data that is immediately previously determined whether the data is targeted for a move is written, then the determining unit (17) stops the process, and, when the process is resumed, the determining unit (17) resumes the process on data that is written in a storage area indicated by an area identifier that is subsequent to the area identifier stored in the determining unit (17).

4. The information processing apparatus (1) according to claim 1 or 2, wherein the determining unit (17) divides the multiple storage areas included in the storage device (7a to 10a) into multiple groups and executes, for each group, a process that determines whether the data written in the storage area in one of the groups is targeted for a move.

5. The information processing apparatus (1) according to any one of claims 1 to 4, wherein
when the result of an update of the count value indicates that the count value corresponds to a predetermined value, the counting unit (16) returns the count value to an initial value, and
when a value obtained by adding 1 to the count value of the counting unit (16) matches the value stored in the count value storing unit (11), the determining unit (17) determines that the data that is associated with the value is targeted for a move.

6. The information processing apparatus (1) according to any one of claims 1 to 4, further composing:
a request counting unit that counts the number of read requests for data issued to the storage device (7a to 10a) or the number of write requests for data issued to the storage device (7a to 10a); and
a setting unit that sets, in accordance with the number of the read requests or the write requests counted by the request counting unit, a threshold that is used to determine whether the data is targeted for a move, wherein
when a value obtained by adding the count value of the counting unit (16) to the threshold that is set by the setting unit is equal to or greater than the value stored in the count value storing unit (11), the determining unit (17) determines that the data that is associated with the value stored in the count value storing unit (11) is targeted for a move.

7. The information processing apparatus (1) according to claim 6, wherein
the request counting unit counts, for each storage area, the number of the read requests that are issued or the number of the write requests that are issued,
the setting unit sets, for each storage area, the threshold in accordance with the number of the read requests or the write requests counted by the request counting unit, and
when the value obtained by adding the count value of the counting unit (16) to the threshold that is set by the setting unit is equal to or greater than the value that is stored in the count value storing unit (11) and that is associated with the data written in the storage area, the determining unit (17) determines, for each storage area included in the storage device (7a to 10a), that the data written in the storage area is targeted for a move.

8. A control program (30) causing a computer to execute a process comprising:
updating a count value when a process that determines whether data stored in each of multiple storage areas included in a storage device (7a to 10a) is targeted for a move has been executed on all pieces of data stored in the storage device (7a to 10a);
storing, in a predetermined storing unit when the data is written in the storage device (7a to 10a), the count value associated with the data; and
comparing, for each data stored in the storage device (7a to 10a), a value stored in the predetermined storing unit with the count value to determine whether each piece of the data is targeted for a move.

9. A method for controlling an information processing apparatus (1), the method comprising:
updating a count value when a process that determines whether data stored in each of multiple storage areas included in a storage device (7a to 10a) is targeted for a move has been executed on all pieces of data stored in the storage device (7a to 10a);
storing, in a predetermined storing unit when the data is written in the storage device (7a to 10a), the count value associated with the data; and
comparing, for each data stored in the storage device (7a to 10a), a value stored in the predetermined storing unit with the count value to determine whether each piece of the data is targeted for a move.
